# EUROPEAN PATENT APPLICATION

(11) **EP 1 796 453 A1**
(43) Date of publication of application: **13.06.2007**
(21) Application number: 05785944.9
(22) Date of filing: 21.09.2005
(51) Int. Cl.: H05K 13/08

(54) **MAINTENANCE METHOD AND COMPONENT MOUNTER**

(30) Priority: 28.09.2004 JP 2004282605; 04.10.2004 JP 2004291816; 06.01.2005 JP 2005001541
(71) Applicant: MATSUSHITA ELECTRIC INDUSTRIAL CO., LTD., Osaka 571-8501 (JP)
(72) Inventor: KURIBAYASHI, Takeshi Matsushita El. Ind. Co., Ltd, Chuo-ku, Osaka-shi. Osaka 540-6319 (JP); MAENISHI, Yasuhiro Matsushita El. Ind. Co., Ltd, Chuo-ku, Osaka-shi. Osaka 540-6319 (JP); KOBAYASHI, Tokumi Matsushita El. Ind. Co., Ltd, Chuo-ku, Osaka-shi. Osaka 540-6319 (JP); NISHIDA, Hiroyoshi Matsushita El. Ind. Co., Ltd, Chuo-ku, Osaka-shi. Osaka 540-6319 (JP); OKAMURA, Hiroshi Matsushita El. Ind. Co., Ltd, Chuo-ku, Osaka-shi. Osaka 540-6319 (JP)
(74) Representative: Pautex Schneider, Nicole Véronique
(86) International application number: PCT/JP2005/017407
(87) International publication number: WO 2006/035651

(57) **Abstract**

Provided is a maintenance method which makes it possible to collectively and quantitatively detect maintenance timings of parts included in respective devices in a component mounter. A management apparatus determines a position of an equipped device using a RF-tag reader/writer (S1001). Then, from the RF tag, the RF-tag reader/writer obtains maintenance information regarding parts in the device (S1002). Then, the determination unit determines a maintenance timing of each of the parts, by comparing maintenance information recorded in a maintenance reference information storage unit to the maintenance information of each part which has been obtained at S1002 (S1003). Next, if it is not yet the maintenance timing (N0 at S1003), then the determination unit (608) ends the determining processing. On the other hand, if it is the maintenance timing (YES at S1003), then the determination unit (608) instructs a warning unit to provide warning (S1004) and stops driving of the component mounter.

## Description

### Technical Field

The present invention relates to a maintenance method of maintaining a component mounter which mounts electronic components onto a board, and particularly to a maintenance method of maintaining devices included in the mounter and parts included in the device.

### Background Art

Conventionally, in a component mounter (simply "mounter") which mounts electronic components onto a printed board, the components, which are stored in or fixed on a component tape, are taken out by pulling out the component tape from a reel around which the tape is wound, and then the taken electronic components are picked up from the component tape by nozzles on a pickup head, and eventually mounted onto the board while being monitored using a recognition camera, for example.

With multiple-nozzle heads each having pickup nozzles conforming to various types of components, a recent mounter has been designed so as to be able to mount almost all types of electronic components (from 0.4 mm by 0.2 mm chip resistors to 200 mm connectors, as mountable components), with a board production line being formed by arranging the required number of such mounters in a line.

Devices, such as nozzles and component feeder cassettes storing the components, which are included in the mounter, are basically consumable devices, so that when the number of uses or a used time period reaches a use limitation value, maintenance is necessary to perform, for example, device interchanging. This maintenance prevents reduction of a pickup rate of picking components and a mounting rate of mounting onto the board.

Here, a component mounting method and a component mounting device are disclosed, in which an accumulated number of components taken out from the component feeder cassette is recorded into a memory of the component feeder cassette, then the number is compared to a lifetime usable number, and eventually a warning for maintenance requirement is provided (patent reference 1, for example).

Moreover, in the mounter which mounts components onto a board such as a printed board, it is necessary to appropriately manage stocks of component tapes used in the component mounting. For the appropriate management of the component tape stocks, it is necessary to manage the number of components consumed in the mounter. Conventionally, as the method of managing the number of components consumed in the mounter, a method has been proposed to detect movement of a rocking lever which transports the components to positions where the components are taken out from the component tape, using permanent magnets or lead switches attached to the rocking lever, and then subtract the number of components memorized in the memory of the mounter, every time a components is taken out.

As described above, by managing the number of components, it is possible to perform, for example, checking of an amount and the number of the components.

Here, the "component tape" refers to a tape (a carrier tape) on which a plurality of the same type of components are arranged, with such tape being supplied from a reel (a supply reel) or the like around which the tape is wound. Component tapes are usually used to supply relatively small components called "chip components" to a mounter. Note that the "component types" means types of components, such as resistors and capacitors.

Note also that the components supplied by the component tape are also referred to as taped components.
Patent Reference 1: Japanese Unexamined Patent Application Publication No. 2000-208987
Patent Reference 2: Japanese Patent Publication No. 2988029

### Disclosure of Invention

### Problems that Invention is to Solve

However, in the mounter as disclosed in the patent reference 1, in the case, for example, where component information regarding components in a plurality of component feeder cassettes or the like is to be obtained, an operator needs to read the information using a reader from a memory of each of the component feeder cassettes, or the reader has to move to scan a memory of each of the component feeder cassettes, in order to obtain component information regarding each component tape. As a result, there is a problem of taking a time to obtain the component information, which eventually requires a time prior to start of production. In general, the number of component feeder cassettes set and used in a mounter is 50 to 100 or more, so that reading information from these feeder cassettes by manual procedures or reader moving causes significant bothering procedures and tact losses. However, such bothering procedures are inevitable for appropriate maintenance and good product quality.

Further, maintenance of interchanging devices in the mounter is usually performed for each device, such as a nozzle and component cassette, when appearance of the device such as the component cassette looks old, or when an obvious trouble occurs in the device such as a nozzle, for example. For example, the maintenance management according to the above patent reference 1 is a method of maintaining component cassettes, not parts in the component cassette such as a spring. More specifically, as one example, a component cassette includes a various kinds of parts, such as a spring, a shutter, a feeding part. However, respective maintenance timings of the respective parts, such as lifelong usable numbers and maintenance check timings, are different, so that, for more appropriate maintenance management for the mounter, it is necessary to learn maintenance information regarding each of the parts. Therefore, the conventional techniques have a problem that the maintenance is not able to be performed for each of the parts.

Furthermore, conventionally, when maintenance is performed for a component cassette, for example, an operator needs to specify a troubled part, such as a spring, so that the specifying of the troubled part also requires bothering procedures.

Then, in some cases such a trouble occurs irregularly, so that a mounter operator has to perform unscheduled maintenance every time such a trouble occurs. As a result, in the maintenance, a device such as a component cassette, which is still able to be used, is misjudged to be changed to a new cassette and then disposed, which results in an economic problem.

Still further, in the component number management method as disclosed in the above patent reference 2, the number of components to be used is memorized in a memory, prior to the component number management. Information of the component number is recorded in a barcode attached to the reel around which a component tape is wound. Therefore, the component number information is previously read out from the barcode using a barcode reader, and then written into a memory in the mounter, which causes another problem of necessity of bothering procedures. In general, types of component tapes used in one mounter vary from 20 to 50, or sometimes reach 100 or more, so that an operator needs to transfer information of respective component tapes to memories of respective component cassettes.

Still further, for such a component tape, a barcode is used, but the barcode is not able to be used as a memory into which information is written. Therefore, in the case where there are redundant components after completion of component mounting, it is necessary to issue a new barcode in which the number of the redundant components is recorded and replace the old barcode to the new barcode, so that there is still another problem of necessity of bothering procedures.

Still further, in order to count the number of redundant components, the component tape needs to be temporarily taken out from the reel and set in a machine which reads the number of the components from the tape, so that there is still another problem of necessity of bothering procedures.

In a view of the above problems, an object of the present invention is to provide a maintenance method, a component mounter, and the like, which make it possible to collectively obtain all maintenance information regarding respective devices, such as component cassettes, which are used in the mounter, and also to provide a maintenance method, a component mounter, and the like, which make it possible to maintain the mounter not only in units of the devices, but also in units of parts included in the device, and to quantitatively check the maintenance information.

Another object of the present invention is to provide a maintenance method and the like, which makes it possible to manage the number of components using a simple procedure.

### Means to Solve the Problems

The maintenance method according to the present invention is a maintenance method for maintaining a component mounter which mounts a component onto a board. The method includes steps of: reading maintenance information regarding maintenance for each of devices included in the component mounter or each of parts included in the device, from a radio frequency (RF) tag attached to the device; and determining whether or not maintenance is necessary for the part, based on the read maintenance information.

Thereby, in the reading, it is possible to read the maintenance information regarding each device or each part from the RF tag, and in the determining, it is possible to determine necessity of maintenance for each device or each part, so that it is possible to quantitatively check a maintenance timing of each part, such as a spring or a filter, included in each device, such as a nozzle or a component cassette. Here, the component means not only an electronic component, but also any types of components to be mounted on a board, such as an optical system component.

It is preferable that the maintenance method further includes a step of determining a position of the device, using a signal received from the RF tag attached to the device included in the component mounter, wherein, in the reading, the maintenance information is read from the RF tag attached to the device located at the position determined in the determining of the position.

Thereby, in order to read the component information by the reader from the RF tag, the reader is capable of surely reading the maintenance information of each device even if the reader is far from the RF tag. Therefore, only one reader is enough to obtain the maintenance information regarding each of devices without moving the devices, by specifying a position of each device and reading the information from the RF tag attached to the specified device. It is possible to distinguish a plurality of devices and collectively obtain all maintenance information of these devices, which makes it possible to reduce a time required to read these maintenance information and thereby shorten a production time.

It is further preferable that the maintenance method further includes a step of warning when the maintenance is determined necessary in the determining of the maintenance necessity.

By the warning when the maintenance is determined necessary in the determining, it is possible to prevent problems, such that a mounting rate is reduced when a device to be changed to another new device is still be used in mounting.

It is still further preferable that the maintenance method further includes a step of writing a use history of the device or the part, as the maintenance information, into the RF tag, during driving the component mounter or during stopping the driving.

Thereby, in the writing, it is possible to update anytime the maintenance information such as the number of uses of each device or each part after component mounting, so that the maintenance information becomes more accurate information.

It is still further preferable that in the writing, the maintenance information is reset to an initial value to be written, when the device or the part is interchanged for another device or another part, the maintenance information being regarding each device or each part and recorded in the RF tag.

Thereby, it is possible to appropriately manage the maintenance timing, such as the number of uses, which is different for each of the parts.

It is still further preferable that the maintenance information includes at least one of a maximum acceleration, shock resistance, a temperature, and humidity, the maximum acceleration and the shock resistance being regarding the component cassette as the device, and the temperature and the humidity being environment values, and in the determining of the maintenance necessity, maintenance is determined necessary for the component cassette, when one of the maximum acceleration, the shock resistance, and the temperature, and the humidity, which are set for the component cassette, reaches a use maximum value.

Thereby, by recoding various information as the maintenance information into the RF tag, it is possible to appropriately perform maintenance management of the component mounter.

It is still further preferable that the RF tag is attached to a component storage body in which the component is stored the maintenance information includes the number of the components stored in the component storage body,in the reading, the number of the components is read from a RF tag attached to the component storage body, and that the maintenance method further includes steps of:updating the read number of the components, when the components are mounted onto the board; and writing the updated number of the components into the RF tag.

The information of the number of components is recorded in the RF tag assigned to the component storage body. Thereby, as compared to a barcode, the RF tag results in faster reading of the component number, and shorter time required to write the information into the memory of the mouner.

Still further, into the RF, information is able to be written. Thereby, when the information of the number of components is to be updated, bothering procedures for issuing a new barcode and replacing barcodes are no longer necessary.

Still further, the number of components counted by the mounter is able to be written directly into the RF tag. Thereby, it is not necessary to count the number of remaining components, and bothering procedures for the counting are not necessary.

It is still further preferable that the maintenance metho d further includes steps of detecting a splice between the comp onent tapes; setting the number of the components to a predet ermined value, when the splice between the component tapes is detected.

Thereby, even if the component tapes are spliced, it is possible to automatically reset the number of the components, which makes it possible to always display accurate number of components.

A component number management method according to another aspect of the present invention is a method of managing the number of components in a component tape storing the components to be mounted by the mounter on a board, and the component tape has a slide member which is capable of sliding along the component tape in a longer direction of the component tape. The method includes steps of: calculating the number of components passing the slide member when the component tape passes the slide member in the longer direction of the component tape; and updating the number of the components stored in the component tape, based on the number of components passed the slide member. It is preferable that the above component number management method further includes a step of displaying the number of the components on a numeral value display unit included in the slide member.

Thereby, the slide member having the numeric value display unit is equipped to the component tape, so that the number of remaining components is able to be displayed on the numeric value display unit. As a result, the user is able to learn the number of remaining components only by seeing the numeric value display unit, so that it is possible to manage the number of remaining taped components easily and at low cost. Note that the number of used components may be counted and displayed, instead of the number of remaining components.

It is further preferable that the component number management method further includes a step of detecting an amount of passing when the component tape passes through the slide member in a longer direction of the component tape, wherein in the calculating, the number of components passing through the slide member is calculated based on the passing amount. The above-described component number management method further includes a step of calculating a relative moving direction of the component tape, which is seen from the slide member side, wherein in the updating, the number of the components stored in the component tape is updated based on the calculated passing amount and moving direction.

By obtaining the moving direction of the component tape, it is possible to know whether the component tape is pulled out from the reel or re-wound around the reel. Thereby, if the component tape is pulled out, then the number of remaining components is decreased, while if the component tape is re-wound, the number of remaining components is increased, so that it is possible to display accurate number of remaining components stored in the component tape. When the number of used components is displayed instead of the number of remaining components, if the component tape is pulled out, then the number of used components is increased, while if the component tape is re-wound, the number of used components is decreased.

It is still further preferable that, in the component number management method, the number of the components is the number of remaining components, and that the component number management method further includes a step of warning when the number of remaining components becomes equal to or less than a predetermined number.

By warning prior to running out of the components, it is possible to interchange component tapes speedily.

A slide member according to still another aspect of the present invention is a slide member which is capable of sliding along a component tape in a longer direction of the component tape. The component tape stores components to be mounted by the mounter onto a board. The slide member includes: a component number calculating unit which calculates the number of the components passing the slide member when the component tape passes the slide member in the longer direction of the component tape; and a component number updating unit which updates the number of the components stored in the component tape, based on the number of components passing the slide member. It is preferable that the slide member further includes a component number displaying unit which displays the number of the components.

Thereby, the component tape includes the slide member having the component number displaying unit which can display the number of the components. Thereby, the user is able to learn the number of remaining components only by seeing the component number displaying unit, so that it is possible to manage the number of remaining taped components easily and at low cost. Note that the number of used components may be counted and displayed, instead of the number of remaining components.

Moreover, in order to achieve the above objects, the present invention can be realized as a component mounter having units executing the characterized steps in the maintenance method, and as a program causing a computer to execute the steps. It is obvious that the program is able to be distributed via a recording medium such as a CD-ROM, or a transmitting medium such as the Internet.

### Effects of Invention

According to the maintenance method of the present invention, a reader can collectively read respective information from the respective RF tags in respective devices, so that the maintenance information can be obtained easily, preventing a complicated structure of the mounter. Further, a position of each of the devices can be specified immediately when the device is set in the mounter, and maintenance information can be read out from the device corresponding to the specified position.

Furthermore, maintenance information regarding parts, such as a spring and a filter, included in each device in the mounter can be recorded and managed in the RF tag, so that maintenance can be performed for each of parts included in the device. Then, by comparing the maintenance information to maintenance reference information, such as the number of usable times and a usable time period, which are set for each part, it is possible to quantitatively check a maintenance timing of each part.

Still further, according to the present invention, it is possible to manage the number of the components using a simple procedure.

It is possible to provide a component number management method of managing the number of remaining taped components easily and at low cost.

### Brief Description of Drawings

[FIG. 1] FIG. 1 is a block diagram showing a structure of a component mounting system according to the first embodiment of the present invention.
[FIG. 2] FIG. 2 is a plan view showing a main structure of the mounter of FIG. 1.
[FIG. 3] FIG. 3 is an external view of a line gang pickup head.
[FIG. 4] FIG. 4 is an external view for explaining a position of a RF tag attached to a nozzle of the mounter.
[FIG. 5] FIG. 5 is an external view for explaining a RF tag attached to a component tape used in the mounter.
[FIG. 6] FIG. 6 is an external view of a motor-type (self-propelled) component cassette to which a RF tag storing maintenance information is attached.
[FIG. 7] FIG. 7 is an external view of a component cassette feeding component automatically with pitches, to which a RF tag storing maintenance information is attached.
[FIG. 8] FIG. 8 is a block diagram showing a hardware configuration of a management apparatus.
[FIG. 9] FIG. 9 is a diagram of tables showing one example of the maintenance information recorded in the RF tag attached to the device.
[FIG. 10] FIG. 10 is a dialog for explaining a method of specifying Z numbers of the component tapes using the RF tag.
[FIG. 11] is a diagram for explaining a method of obtaining component information from RF tags of respective component cassettes arranged in the Z numbers in the mounter.
[FIG. 12] FIG. 12 is a flowchart showing processing performed by the mounter to perform maintenance management for parts using number/time management information.
[FIG. 13] FIG. 13 is a flowchart showing processing performed by a RF-tag reader/writer of the mounter to update maintenance management after completing mounting onto a board.
[FIG. 14] FIG. 14 is a flowchart showing processing performed by the mounter to perform maintenance management for devices using information regarding quality management.
[FIG. 15] FIG. 15 is a flowchart showing processing performed by the mounter to check a setup relationship between electronic components and a component cassette.
[FIG. 16] FIG. 16 is a flowchart showing processing performed by the mounter to manage a use deadline of electronic components.
[FIG. 17] FIG. 17 is a table showing corresponding relationships between troubled portions in a nozzle and detection details of various kinds of sensors.
[0051] [FIG. 18] FIG. 18 is an external view showing an overall structure of the component mounting system according to the second embodiment of the present invention.
[FIG. 19] FIG. 19 is a plan view showing a main structure of the mounter in the component mounting system.
[FIG. 20] FIG. 20 is a diagram showing positional relationships between operation heads and component cassettes in a mounter.
[FIG. 21] FIG. 21 is a diagram showing an example of a structure of total four component supply units which two stages in the mounter have.
[FIG. 22] FIG. 22 is a table showing loading numbers and positions in a Z-axis of various types of component cassettes in the structure.
[FIG. 23] FIG. 23 is a diagram showing an example of positions in the Z-axis of component supply units where components can be picked up by a line gang pickup head with ten nozzles.
[FIG. 24] FIG. 24 is a table showing an example of positions in the Z-axis of component supply units where components can be picked up by a line gang pickup head with ten nozzles.
[FIG. 25] FIG. 25 is a view showing an example of various types of chip components to be mounted.
[FIG. 26] FIG. 26 is a view showing another example of various types of chip components to be mounted
[FIG. 27] FIG. 27 is a view showing a still another example of various types of chip components to be mounted.
[FIG. 28] FIG. 28 is a view showing a still another example of various types of chip components to be mounted.
[FIG. 29] FIG. 29 is a view showing an example of a carrier tape storing components and supply reel supplying the tape.
[FIG. 30] FIG. 30 is a view showing an example of a component cassette having a taping component.
[FIG. 31] FIG. 31 is a view showing a positional relationship between a RF-tag reader/writer set in the component cassette and a RF tag on a slide member.
[FIG. 32] FIG. 32 is a view for explaining a path along which electronic components stored in a carrier tape wound around a supply reel is transported to be pickup by a line gang pickup head.
[FIG. 33] FIG. 33 is a diagram showing circuit structures of the FR-tag reader/writer and the RF tag.
[FIG. 34] FIG. 34 is a block diagram showing a hardware configuration of a component stock management apparatus.
[FIG. 35] FIG. 35 is a table showing an example of stock data.
[FIG. 36] FIG. 36 is a view for explaining the component supply unit in more detail.
[FIG. 37] FIG. 37 is a flowchart of processing performed by a user when a component tape is newly stocked into a component tape cabinet.
[FIG. 38] FIG. 38 is a flowchart of processing performed by the component stock management apparatus when a component tape is newly stocked into a component tape cabinet.
[FIG. 39] FIG. 39 is a flowchart of processing performed by the mounter when a component tape is loaded in the mounter.
[FIG. 40] FIG. 40 is a flowchart of processing performed by the component stock management apparatus when a component tape is loaded in the mounter.
[FIG. 41] FIG. 41 is a flowchart of processing performed by the user when the component tape is re-stocked into the component tape cabinet.
[FIG. 42] FIG. 42 is a flowchart of processing performed by the component stock management apparatus when the component tape is re-stocked into the component tape cabinet.
[FIG. 43] FIG. 43 is a view showing a situation where RF tags are attached to trays.
[FIG. 44] FIG. 44 is a view showing a situation where RF tags are attached to sticks.
[FIG. 45] FIG. 45 is an external view showing an overall structure of a component mounting system according to the present invention.
[FIG. 46] FIG. 46 is a view showing an example of a carrier tape storing components and a supply reel supplying the tape.
[FIG. 47] FIG. 47 is a top view showing a slide member of FIG. 46.
[FIG. 48] FIG. 48 is a cross sectional view taken along line A-A of the slide member of FIG. 47.
[FIG. 49] FIG. 49 is a block diagram showing an inside structure of a counter.
[FIG. 50] FIG. 50 is a block diagram showing a hardware configuration of a component number stock management apparatus.
[FIG. 51] FIG. 51 is a diagram showing a detailed example of a component library of FIG. 50.
[FIG. 52] FIG. 52 is a table showing detailed examples of the component library of FIG. 50.
[FIG. 53] FIG. 53 is a table showing detailed examples of mounter information of FIG. 50.
[FIG. 54] FIG. 54 is a diagram showing an example of component arrangement data stored in a component arrangement data storage unit of FIG. 50.
[FIG. 55] FIG. 55 is a view for explaining a structure of a component supply unit in more detail.
[FIG. 56] FIG. 56 is a diagram showing splice of carrier tapes.
[FIG. 57] FIG. 57 is a flowchart of processing performed by a counter.
[FIG. 58] FIG. 58 is a flowchart of processing of calculating a moving direction of component tape, based on outputs of two light sensors.
[FIG. 59] FIG. 59 is a chart showing output voltages of the first light sensor and the second light sensor, when the moving direction of component tape is rightward.
[FIG. 60] FIG. 60 is a chart showing output voltages of the first light sensor and the second light sensor, when the moving direction of component tape is leftward.
[FIG. 61] FIG. 61 is a flowchart of processing of managing the number of remaining components.
[FIG. 62] FIG. 62 is a flowchart of processing of determining a moving direction of a component tape using a dock sensor.
[FIG. 63] FIG. 63 is a flowchart of processing of determining the moving direction of the component tape using the dock sensor and the first light sensor.
[FIG. 64] FIG. 64 is a flowchart of processing of determining the moving direction of the component tape, based on a rotation direction of an axis connected to a counter.

### Numerical References

- 100, 200: component mounter (mounter)
- 111: RF-tag reader/writer
- 112: pickup head
- 113: XY robot
- 114: component cassette
- 115a, 115b: component supply unit
- 116: component recognition camera
- 117: tray supply unit
- 301: nozzle
- 400: RF tag
- 401: reel
- 402: component tape
- 402a: cover tape
- 402b: carrier tape
- 402c: storage concave
- 600: management apparatus
- 601: calculation control unit
- 602: display unit
- 603: input unit
- 604: memory unit
- 605: nozzle information storage unit
- 606: communication I/F unit
- 607: database unit
- 608: determination unit
- 609: warning unit

### Best Mode for Carrying Out the Invention

The following describes a component mounter used in a maintenance method according to the embodiments of the present invention with reference to the drawings.

### (First Embodiment)

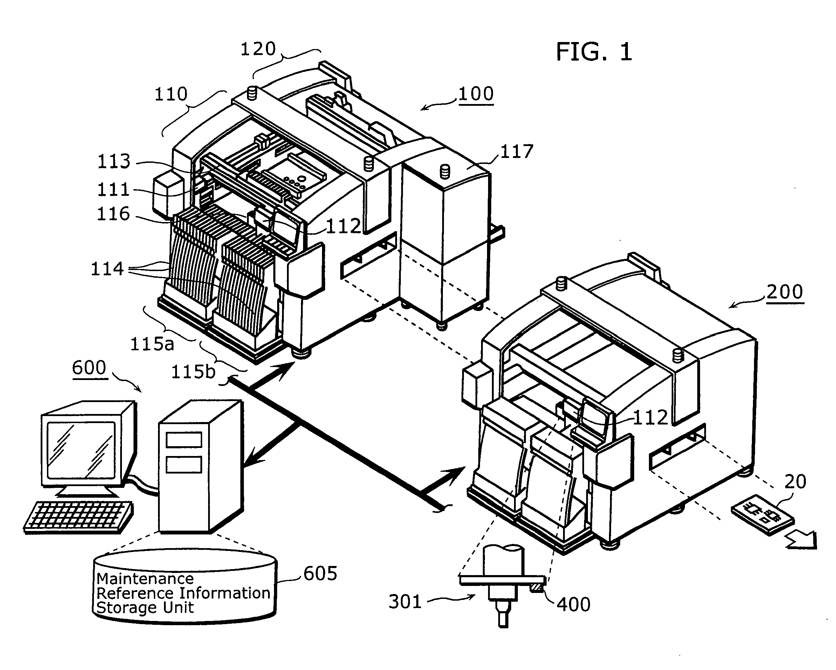

FIG. 1 shows a block diagram showing a structure of a component mounting system according to the present invention.

FIG. 1 is a block diagram showing a structure of a component mounting system according to the first embodiment. Here, the component mounting system according to the first embodiment is characterized in that RF tags are attached to devices, such as nozzles for picking up electronic components and mounting the components on a board, or component cassettes for storing the electronic components, and, by using the RF tags, all of maintenance information regarding respective devices in an component mounter (mounter) 100 are managed in an integrated fashion.

The component mounting system shown in FIG. 1 includes: a plurality of mounters 100 and 200 which configure a production line for mounting electronic components onto a circuit board being transported from the upstream to the downstream; and a management apparatus 600 which performs maintenance management for the mounters 100 and 200.

The mounter 100 is equipped with two stages (a front stage 110 and a rear stage 120) that perform component mounting simultaneously and independently of one another. Each of these stages 110 and 120 is a perpendicular robotic mounting stage, and includes component supply units 115a and 115b, a line gang pickup head 112, an XY robot 113, a component recognition camera 116, a tray supply unit 117, a RF-tag reader/writer 111, and the like.

The component supply units 115a and 115b are each made up of an array of up to 48 component cassettes 114 that store component tapes. The line gang pickup head 112, which is also referred to a ten-nozzle head or simply a head, has 10 pickup nozzles (hereafter simply "nozzles") that can pick up a maximum of 10 components from the component cassette 114 and mount them onto a circuit board 20. The XY robot 113 moves the line gang pickup head 112. The component recognition camera 116 investigates the picked-up state of the components that have been picked up by the line gang pickup head 112 in two or three dimensions. The tray supply unit 117 supplies trays storing components. The RF-tag reader/writer 111 reads information from a RF tag, and writes information to the RF tag. Each of these stages performs each task in component mounting, independently of one another, in other words, in parallel.

Such a RF tag for a nozzle is a memory for non-contact communication using known Radio Frequency Identification (RFI) technology. According to the communication, the RF tag is used to hold and provide information.

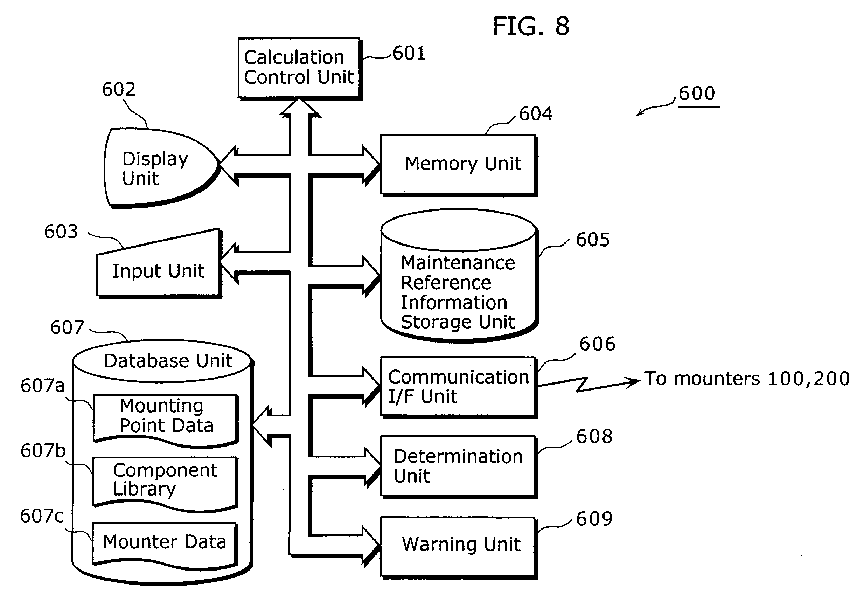

On the other hand, the management apparatus 600 includes a maintenance reference information storage unit 605, which will be described below with reference to FIG. 8. The maintenance reference information storage unit 605 obtains, from the mounter 100, the maintenance information read from the RF tags, and collectively holds the obtained information.

In more detail, the mounter 100 is a mounting apparatus that includes the functions of both a mounting apparatus commonly called a high-speed mounter and a mounting apparatus called a multi-function mounter. A high-speed mounter is an apparatus that is capable of mounting electronic components that are 10 mm² or smaller in around 0.1 seconds, while a multi-function mounter is an apparatus that can mount large electronic components that are 10 mm² or larger, irregularly shaped components like switches and connectors, and IC components like Quad Flat Package (QFP) or Ball Grid Array (BGA) components. In short, the mounter 100 is designed so as to be able to mount almost all types of electronic components (from 0.4 mm by 0.2 mm chip resistors to 200 mm connectors, as mountable components), with a production line for a board 20 being formed by arranging the required number of mounters 100 in a line.

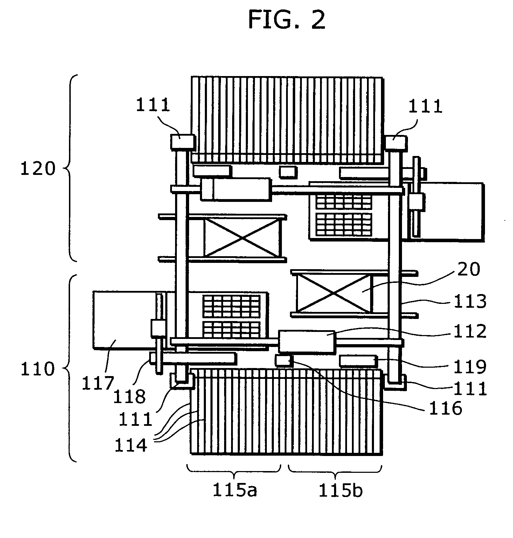

FIG. 2 is a plan view showing a main structure of the mounter 100 of FIG. 1. A shuttle conveyor 118 is a moving table (a collection conveyor) on which a component taken from the tray supply unit 117 is placed and which is moved to a predetermined position where the line gang pickup head 112 can pick up components from the shuttle conveyor 118. A nozzle station 119 is a table on which interchangeable pickup nozzles corresponding to various sizes of components are positioned.

The component supply units 115a and 115b included in each stage 110 or 120 are provided on the left and right sides of the component recognition camera 116. The line gang pickup head 112 picks up components from the component supply unit 115a or 115b, passes by the component recognition camera 116, and then repeats an operation whereby the line gang pickup head 112 moves to a mounting point on the circuit board 20 and mounts one of the picked-up components.

Note that, in this description, the leftmost component supply unit 115a in each stage is referred to as the "left block", while the rightmost component supply unit 115b in each stage is referred to as the "right block". Note also that, in this description, one iteration of the repeated series of processes where the line gang pickup head 112 picks up, transports, and mounts components and the group of components handled in such iteration are both referred to as a "task". As one example, in the case of the line gang pickup head 112 in the mounter 100 of the present invention, the maximum number of components that can be mounted by a single task is ten. It should also be noted that a "pickup operation" refers to all of the operations performed from when the head starts to pick up components to when the line gang pickup head 112 transports the components. In this description, a pickup operation refers not only to when ten components are picked up by to the line gang pickup head 112 with a single nozzle stroke (a raising and lowering of the line gang pickup head 112), but also when ten components are picked using several nozzle strokes.

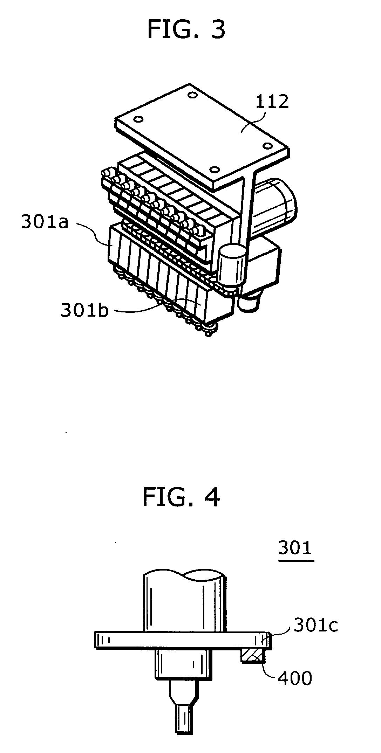

FIGS. 3 and 4 are reference diagrams for explaining a position at which a RF tag 400 is attached in a nozzle 301 of the mounter 100 according to the first embodiment.

FIG. 3 is an external view of the line gang pickup head 112. The line gang pickup head 112 is an operation head using a method referred to as "gang pickup" and can be equipped with a maximum of ten pickup nozzles 301a to 301b (total ten pickup nozzles from the leftmost 1st pickup nozzle 301a to the rightmost 10th pickup nozzle 301b), each of which independently performs pickup and mounting of each component. When thus equipped, the components can be simultaneously picked up from a maximum of ten component cassettes 114, respectively, in one raising and lowering of the line gang pickup head 112. In short, the line gang pickup head 112 moves towards the component supply units 115a and 115b to pick up the components. Here, if the line gang pickup head 112 cannot pickup ten components at once, the line gang pickup head 112 repeats the raising and lowering strokes for several times changing the pickup positions, in order to pick the maximum of ten components.

FIG. 4 is an external view showing an arrangement example of the RF tag 400 attached to the nozzle 301 in the mounter 100 according to the first embodiment. The RF tag 400 is placed, for example, on an edge of a top surface, an under surface, a side surface, or the like of a flange 301c of the nozzle 301. Note that the attachment position of the RF tag 400 may be any positions on the nozzle or places related to the nozzle, as long as the RF tag 400 is attached to the nozzle.

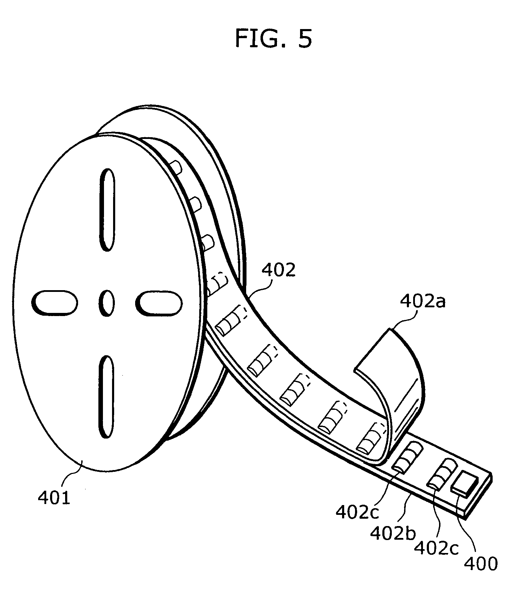

FIG. 5 is an external view for explaining a RF tag 400 attached to a component tape 402 used in the mounter 100 according to the first embodiment.

The component tape 402 is wound around a reel 401, and includes: a carrier tape 402b in which a number of components are arranged; a cover tape 402 which is applied over the carrier tape 402b; and the above-mentioned RF tag 400.

The carrier tape 402b is made of thin resin molding, paper, or the like, and each of the electronic components is stored in each of storage concaves 402c which are arranged in the carrier tape 402b at regular intervals in a longer direction of the carrier tape 402b.

The cover tape 402a is made of transparent synthetic resin, for example, and applied to fix the electronic components in the storage concaves 402c of the carrier tape 402b, in other words, to seal the storage concaves 402c.

The RF tag 400, which is attached to an end of the carrier tape 402b or on a side surface of the reel, holds information necessary for maintenance of the device, such as the number of usable times, a specification of the reel, and a feed pitch. Here, the attachment position of the RF tag 400 may be any positions on the component tape or the reel.

Such a RF tag 400 is previously attached to the carrier tape 402b, and after electronic components are placed and stored in the carrier tape 402b, the above-mentioned maintenance information corresponding to the components is written into the RF tag 400.

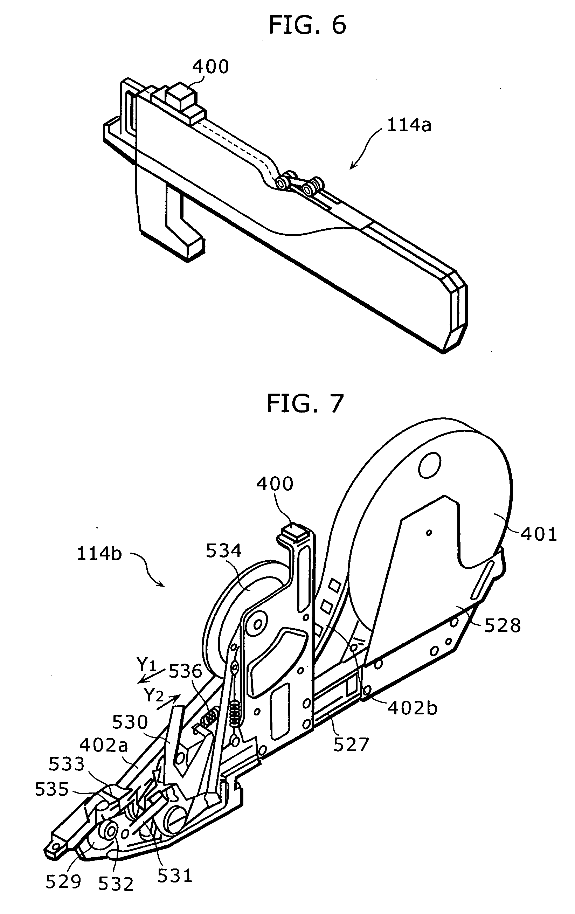

FIGS. 6 and 7 show external views of component cassettes 114 (114a and 114b) to which a RF tag 400 storing maintenance information is attached, according to the first embodiment.

FIG. 6 is an external view of a motor-type (self-propelled) component cassette 114a. In this component cassette, the tape is pull out (fed) being driven by a servomotor, and a feed pitch or a feed speed, for example, is set depending on the components. In the component mounter according to the first embodiment, information necessary for maintenance of the component cassette and parts in the component cassette is written into the RF tag 400 attached to the motor-type component cassette 114a. The information is able to be automatically read by the RF-tag reader/writer 111 in order to automatically set the feed pitch and the like.

On the other hand, FIG. 7 shows an external view of a component cassette 114b which automatically feeds components. The supply reel 401 is attached to reel side plates 528 so as to be freely rotable, with the reel side plates 528 engaging a main frame 527. The carrier tape 402b that has been pulled off the supply reel 401 is guided by a feed roller 529. Movement of a feed lever (not shown) also fitted in the mounter causes a feed lever 530 of the electronic component supply device to move in the direction shown as Y1 of FIG. 7. This movement is transmitted via a link 531 and results in a ratchet 532 rotating by a predetermined angle. Then, the feed roller 529 is disposed so as to move in conjuncture with the ratchet 532, and so moves by a predetermined pitch, such as a feed pitch of 2 mm or 4 mm. For example, in the case where a predetermined pitch is 2 mm and a desired feed amount is 4 mm, the mounter performs operations to move the feed lever 530 twice, in order to feed a tape of 2 mm twice resulting in a total tape of 4 mm.

Moreover, the cover tape 402a is peeled off by a cover tape separating unit 533 that is positioned before the feed roller (towards the supply reel 401). The separated cover tape 402a is re-wound around a cover tape collecting reel 534 and the carrier tape from which the cover tape 425 has been removed is transported to the electronic component obtaining unit 535. As the same time as the carrier tape 402b is fed by the feed roller 529, the electronic component obtaining unit 535 opens in conjunction with the movement of the ratchet 532, and a vacuum suction head (not shown) picks up a chip-shaped electronic component using suction, thereby removing it from a storage concave 402c. After this, the pressing force applied by the feed lever 530 is removed and the force applied by a tension spring 536 caused the feed lever 530 to move in the direction shown as Y2. As a result, the feed lever 530 returns to its original position. The above series of operations is repeated and the spent carrier tape 402b is discharged to the outside of the electronic component supply device.

Moreover, in the component cassette 114b shown in FIG. 7, the RF tag 400 storing maintenance information of the component cassette 114 is attached on the top surface of the main frame 527 which is an outer case of the component cassette 114. In this case, in order to pull out the tape with an amount memorized in the RF tag 400, the mounter needs operations to move the feed lever 530 for multiple times corresponding to the memorized feed amount.

As described above, in the component mounter according to the first embodiment, as shown in FIGS. 3 to 7, the RF tag 400 is attached to a portion of the device, such as a component cassette, of the mounter, and the RF tag 400 stores maintenance information regarding respective parts, such as a spring, included in the device. Note that, in the case of the component cassette 114, examples of the parts are a spring, a shutter, a feeding part, a case, and the like, while in the case of the nozzle 301, examples of the parts are a spring, a filter, a flange, a case, and the like. Note also that the "device" means one of constituent parts which configure the mounter, while the "part" means one of parts which configure the device.

FIG. 8 is a block diagram showing a structure of the management apparatus 600 according to the first embodiment.
This management apparatus 600 is capable of checking the maintenance information regarding parts included in the nozzle for picking electronic components to be mounted onto a board or the component cassette 114 for holding the electronic components. The management apparatus 600 includes a calculation control unit 601, a display unit 602, an input unit 603, a memory 604, a maintenance reference information storage unit 605, a communication I/F unit 606, a database unit 607, a determination unit 608, a warning unit 609, and the like, all of which will be described below in detail.

The calculation control unit 601 is, for example, a Central Processing Unit (CPU), a numeric value processor, or the like. According to instructions or the like from a user, the calculation control unit 601 downloads a program necessary for the memory 604 and then executes the program. Based on a result of the program execution, the calculation control unit 601 controls the other units.

The display unit 602 is, for example, a Cathode-Ray Tube (CRT), a Liquid Crystal Display (LCD), or the like.

The input unit 603 is, for example, a keyboard, a mouse, or the like. These units are used under the control of the calculation control unit 601, so that the mounter 100 and the operator can communicate with each other.

The memory 604 is, for example, a Random Access Memory (RAM) or the like, which provides a working area for the calculation control unit 601.

The maintenance reference information storage unit 605 stores information regarding maintenance for each of the parts included in the nozzle 301 or the component cassette 114. Such information includes, for example, the number of usable times, a usable time period, the number of pickup-able times, the number of mount-able times, a maintenance timing, and the like. The information is regarding each of devices, such as the nozzle 301 or the component cassette 114, or regarding each of parts included in the device. Note that the number of pickup-able times is a maximum number of times within which the pickup head can pick electronic components using the part, and that the number of mount-able times is a maximum number of times within which the pickup head can mount electronic components on a board using the part.

In addition to the above information, the maintenance reference information storage unit 605 further holds, as maintenance reference information, a specification of the component tape or the component cassette, for example, material of the tape, such as paper or emboss, a tape width, a feed pitch, and the like. The maintenance reference information storage unit 605 may still further hold information indicating to which component cassette the component tape is to be set (an allowable relationship between a component cassette specification and a component tape specification), and the like.

The communication I/F unit 606 is, for example, a Local Area Network (LAN) adapter or the like, which is used when the management apparatus 600 and the mounter 100 communicate with each other, for example.

The database unit 607 is a hard disk, in which input data (mounting point data 607a, component library 607b, and mounter data 607c) used in the mounter 100, and the like are stored.

The determination unit 608 determines whether or not maintenance is necessary for each of the parts in component mounting, based on maintenance information of the part which is read out by the RF-tag reader/writer 111 and the maintenance reference information of the part, such as the number of usable times, which is stored in the maintenance reference information storage unit 605.

According to instructions from the determination unit 608, the warning unit 609 controls a ramp equipped in the mounter 100 to emit yellow warning or red warning, when the determination is made that maintenance is necessary for the part.

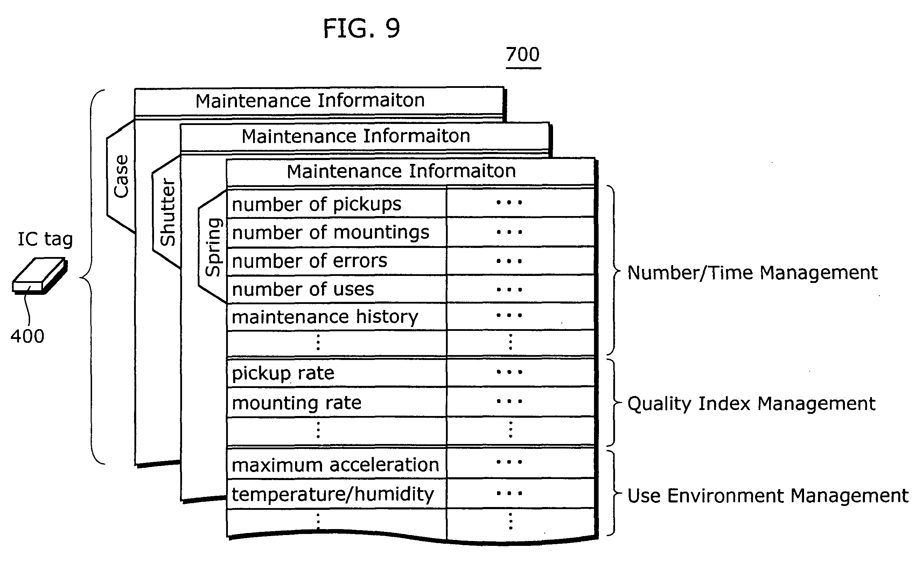

FIG. 9 shows tables 700 showing one example of the maintenance information recorded in a RF tag 400 attached to a device, such as a nozzle or a component cassette, according to the first embodiment. Note that, in the first embodiment, in order to manage maintenance information for each of parts included in the component cassette, the RF tag 400 attached to the component cassette, for example, holds maintenance information of respective parts, such as a spring, a shutter, and a case.

As shown in the tables 700, the maintenance information recorded in the RF tag 400 includes: information regarding number/time management, such as the number of pickups, the number of mountings, the number of errors, the number of uses, a maintenance history, and a used time period (not shown); information regarding quality index management, such as a pickup rate and a mounting rate; and information regarding use environment management, such as maximum acceleration, and temperature/humidity. The number of pickups is the number of times for which the pickup head has picked electronic components using the part. The number of mountings is the number of times for which the pickup head has mounted electronic components on a board using the part. The number of errors is the number of errors caused by the part. The number of uses is the number of times for which the part has been used. The maintenance history is a history of maintenance, such as when the part was interchanged. The used time period is a time period (accumulated period) during which the part have been used. Further, the pickup rate is a rate of the number of pickups without errors to a total number of pickups for which the pickup head has picked electronic components using the part. The mounting rate is a rate of the number of mountings without errors to a total number of mountings for which the pickup head has mounted electronic components on a board using the part. Still further, the maximum acceleration is a maximum acceleration allowable for the part. The temperature/humidity are ranges of temperature and humidity allowable for the part.

The above-mentioned information regarding use environment management is used, for example, when the management apparatus 600 checks whether or not acceleration measured by an acceleration measurement sensor reaches the use maximum set for each of component cassettes, by recording a maximum acceleration (G) of each component cassette of a rotary machine into a RF tag at the component cassette. Here, the rotary machine is a mounter, in which pickup heads have rotation mechanism, the component supply tables determine, at a high speed and high acceleration, respective positions to which the tables moves in order to supply electronic components, and eventually the electronic components can be mounted at a high speed. Then, if the measured acceleration exceeds the maximum acceleration, use of the component cassette is stopped to perform maintenance. Besides the maximum acceleration, the information regarding use environment management further includes use environment values regarding periphery of the mounter, such as temperature and humidity. Also regarding these use environment values, each actual value of each use environment is measured, and it is checked whether or not the measured value matches the use environment value recorded in the RF tag 400 (or whether or not the measured value is within a range represented by the use environment value, whether or not the measured value exceeds an upper limit represented by the use environment value, or the like).

Moreover, there is a problem that the operator would drop the component cassette 114 during the operation, and the dropping results in reduction of component mounting accuracy in the mounting. In order to prevent the above problem, it is also possible, as one example, to attach a schock sensor to each component cassette and the RF-tag reader/writer 111 reads a value detected by the impact sensor, so that the determination unit 608 can monitor not to use the component cassette 114 which is shocked with a degree equal to or more than a predetermined value. In other words, as the use environment value recorded in the RF tag 400, shock resistance (maximum shock resistance) may be further added.

Note that the information regarding number/time management, such as the number of pickups, the number of mountings, the number of errors, the number of uses, the maintenance history, and the used time period (not shown), and the information regarding quality index management, such as the pickup rate and the mounting rate are measured during mounting and written by the RF-tag reader/writer 111 into the RF tag 400 for each part during driving the mounter or during stopping the mounter after driving.

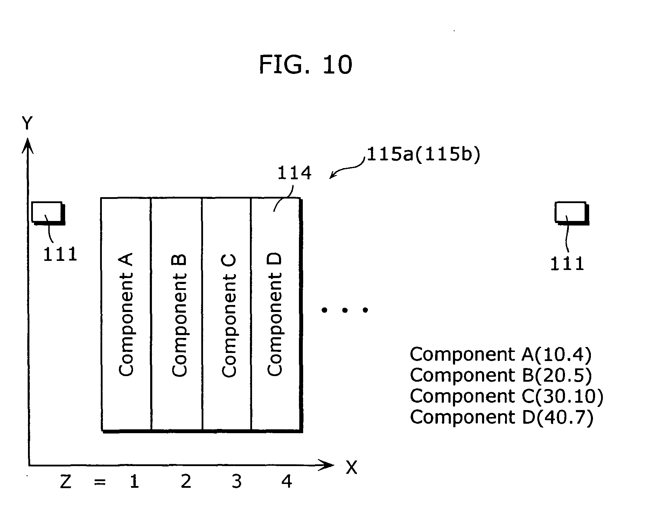

FIG. 10 is a graph for explaining a method of identifying Z numbers of respective component tapes using the RF tags 400. Here, the Z numbers are values indicating an order of arranging component tapes or component cassettes in a mounter. The Z numbers are one example of position information of component tapes or component cassettes in a mounter.

The RF-tag reader/writer 111 sends radio waves of a predetermined frequency including a read command to the RF tag 400, and receives radio waves of a predetermined frequency including information recorded in the RF tag 400. Then, two RF-tag reader/writers 111 determine a position of the RF tag 400, based on the respective directions of the radio waves received from the RF tag 400. By determining the position of the RF tag 400, a Z number of the RF tag 400 is identified. For example, in the coordinate system as shown in FIG. 10, it is assumed that a Z number is increased with 1 when an X-coordinate value is increased with 10. In this case, when a position of a component A is determined as (X, Y) = (10, 4), it is understand that a Z number of the component A is 1 according to the X coordinate. Here, using two RF-tag reader/writers 111, in order to receive maintenance information of a component cassette and a component tape from the RF tag 400, a name and a Z number of the electronic components stored in the component cassette 115 are specified based on the information received from the RF tag 400.

Therefore, according to the mounter 100 of the present invention, it is possible to manage the Z number (position information of the device) and maintenance information read from the RF tag in association with each other. More specifically, although, conventionally, a reader has moved to access, in other words, an operator has needed to perform reading for each of devices to be maintained, it is now possible to collectively manage such maintenance information immediately when the devices to be maintained are set in the mounter. For example, it is possible to manage, for each Z number, maintenance information of a component cassette or maintenance information of electronic components, such as information indicating in which Z number which type of component cassette is set, or which type of electronic components (component name) is stored.

Moreover, according to the structure of the RF-tag reader/writers 111 shown in FIG. 10, it is possible to access all of a RF tag 400 of the component tape, a RF tag 400 of the component cassette 114, a RF tag 400 of the nozzle 301, and RF tags attached to other devices.
Note that the method of determining positions of the RF tags is not limited to the method using the directions of radio waves, but may be any methods using, for example, strength or a ratio of the strength of radio waves received by two RF-tag reader/writers 111. Note also that the number of RF-tag reader/writers 111 are not limited to two, but may be one as far as positions of the RF tag 400 can be determined using strength or directions of received radio waves.

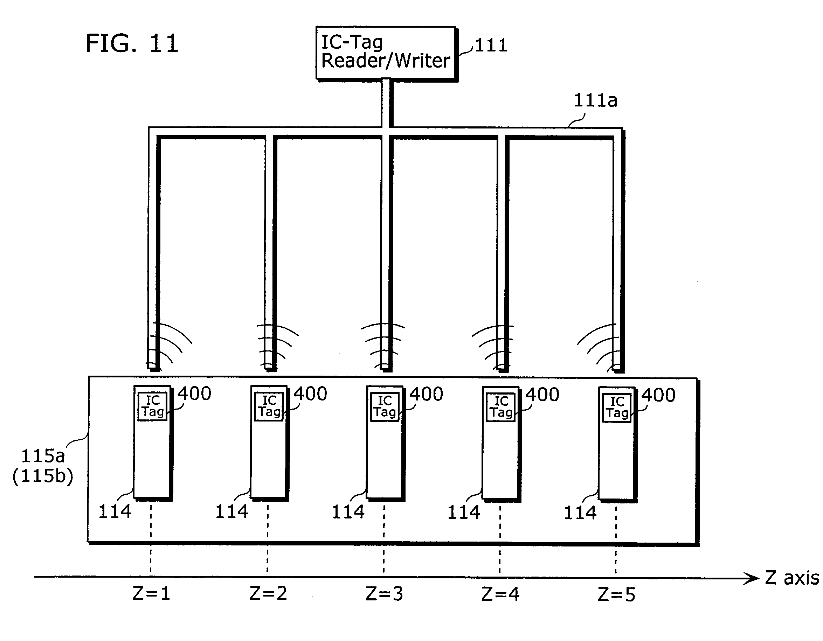

FIG. 11 is a diagram for explaining another method of obtaining maintenance information from RF tags 400, for respective component cassettes 114 arranged in the Z numbers in the mounter 100 or 200. This method is a variation of the method of identifying the Z numbers shown in FIG. 10.

For example, the mounter 100 or 200 has one RF-tag reader/writer 111 and an antenna 111a which is extended to reach each of the RF tags 400 of respective component cassettes 114 in the component supply unit 115a or 115b. Note that a combination of the RF-tag reader/writer 111 and the antenna 111a forms a component information obtainment device.

As explained above, the antenna 111a is extended to reach each of the RF tags 400, so that the RF-tag reader/writer 111 can surely obtain component information from each of the RF tags 400, even if the RF-tag reader/writer 111 itself is far from the RF tags 400. Furthermor, the RF-tag reader/writer 111 determines respective positions of the RF tags 400, in other words, respective Z numbers of the component cassettes 114, based on output signals (strength or directions of radio waves, for example) of the respective RF tags 400.

Therefore, the mounter 100 or 200 according to the first embodiment can easily obtain maintenance information of the component cassettes 114 equipped according to the Z numbers, without moving the component supply units or having a plurality of readers as the conventional technologies. Furthermore, in addition of aspects of the method shown in FIG. 10, the method shown in FIG. 11 has a further aspect in which the antenna 111a is arranged to be by each of the RF tags 400, so that sensitivity in radio-wave receiving is more reliable than the method of FIG. 10 and maintenance information can be surely obtained from the RF tag 400 of the component cassette 114, the RF tag 400 of the nozzle 301, and the like.

Note that, in the case where the component cassette has double cassettes storing two component tapes, the two component tapes exist in the same Z number, but positions of respective RF tags 400 attached to the respective supply reels 426 of the respective component tapes are different from each other, so that, based on the RF tags 400 attached to the respective supply reels 426, the RF-tag reader/writer 111 can determined whether a sender of signals is a left component tape in the double-cassette cassette or a right component tape in the double-cassette cassette.

Note also that in the case where the RF tags 400 outputs signals by electromagnetic waves or infra-red radiation as a radio communication medium, the RF-tag reader/writer 111 may determine positions of the RF tags 400 based on strength and directions of the signals.

Note also that, in FIGS. 10 and 11, the explanation has been given using the component cassette 114, but even if a plurality of nozzles 301 or the like are equipped in the pickup head, for example, the determining of positions of the RF tags 400 at the devices can be performed.

As described above, according to the mounter of the first embodiment, it is possible to distinguish a plurality of devices and obtain maintenance information of these devices at once, which makes it possible to reduce a time required to read the maintenance information and shorten a production time.

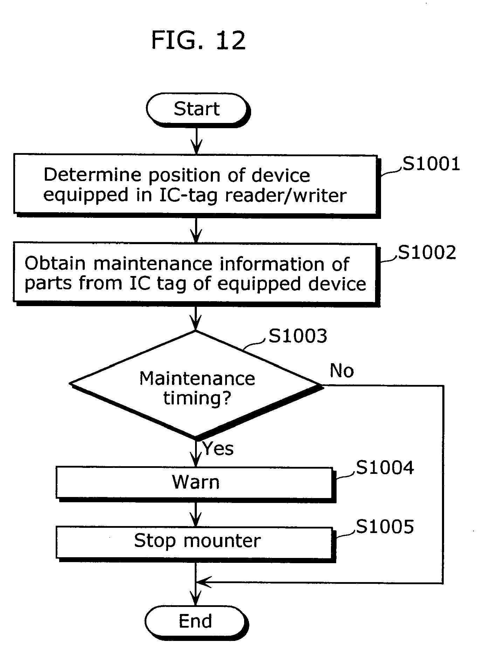

FIG. 12 is a flowchart showing processing performed by the mounter 100 of the first embodiment to perform maintenance management for a device or parts, using the number/time management information.

Firstly, in the management apparatus 600, the RF-tag reader/writer 111 determines whether or not a device is equipped in a predetermined position in the mounter, and the RF-tag reader/writer 111 determines the positions of the equipped device in the manner described as above (S1001).

After that, from a RF tag 400 attached to the equipped device, the RF-tag reader/writer 111 obtains maintenance information of parts included in the device (S1002).

Next, the determination unit 608 compares (i) the number of uses, the number of pickups, the number of mountings, a used time period, and the like regarding corresponding part, which are actual values obtained at S1002, to (ii) the number of usable times, the number of pickup-able times, the number of mount-able times, a usable time period, and the like regarding each of the parts, which are predetermined values indicating necessity of maintenance and recorded in the maintenance reference information storage unit 605, respectively, so that it is determined whether or not the part is to be maintained (S1003). As a result, if the actual number of uses or the like regarding the part exceeds the number of usable times recorded in the maintenance reference information storage unit 605 which indicates that the part needs maintenance, then it is determined that the part is in a maintenance timing. Moreover, the determination unit 608 compares (i) the information obtained at S1002, to (ii) another number of usable times, another number of pickup-able times, another number of mount-able times, another usable time period, and the like regarding the part, which are recorded in the maintenance reference information storage unit 605, respectively. If the information exceeds the corresponding information, the determination unit 608 determines as "use limit".

Then, if the determination is made that the part is not at the maintenance timing (No at S1003), then the determination unit 608 terminates the processing. On the other hand, if the determination is made that the part is at the maintenance timing (Yes at S1003), then the warning unit 609 is notified to present a yellow signal when maintenance is necessary for coming a use limit, and to present a red warning when the "use limit" has already been reached (S1004), and the driving of the mounter 100 is stopped (S1005). Note that the yellow signal warnings in order to notify how many times the part will be able to be used, or how many hours the part will be able to be used for the production. Note also that, in addition to the color display, the warning may be presented as sounds. Note also that the maintenance method according to the first embodiment can manage a management limit of overall devices, such as the component cassette 114 and the nozzle 301.

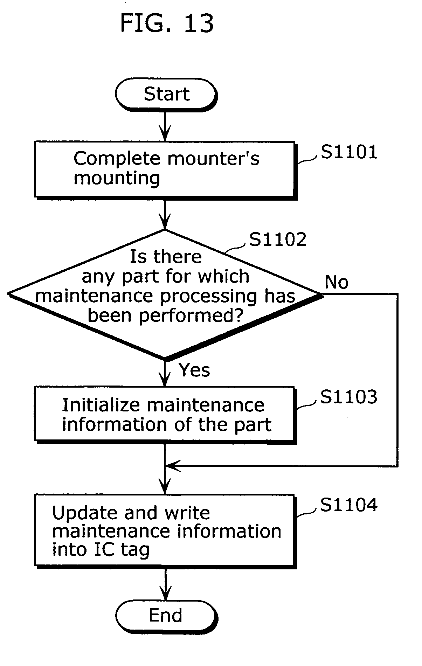

FIG. 13 is a flowchart showing processing performed by the RF-tag reader/writer 111 of the mounter 100 of the first embodiment, to update the maintenance information after completing mounting components onto a board. Note that, in the first embodiment, it is characterized in that maintenance information of some parts are initialized when maintenance, such as interchanging, has been already performed for these parts.

Firstly, when driving of the mounter 100 is ended (S1101), the determination unit 608 determines whether or not there is any part for which maintenance has been performed (S1102). Then, if interchanging or the like has been performed for some part (Yes at S1102), then RF-tag reader/writer 111 initializes maintenance information of the part recorded in a RF tag 400 (S1103), and then the RF-tag reader/writer 111 updates information necessary for maintenance, such as the number of uses and a used time period, to be written into the RF tag 400 attached to the used device (S1104).

On the other hand, if the determination unit 608 determines that maintenance has not been performed for any parts (No at S1102), then the RF-tag reader/writer 111 updates information necessary for maintenance, such as the number of uses and a used time period, regarding respective parts in the used device, to be written into the RF tag 400 attached to the device (S1104). Note that timing of the writing by the RF-tag reader/writer 111 may be after completion of component mounting or every time after each task.

By such maintenance information initialization, the information is updated in synchronization with part interchanging and accurate maintenance information is held for each of the parts, which makes it possible to perform maintenance at appropriate timing.

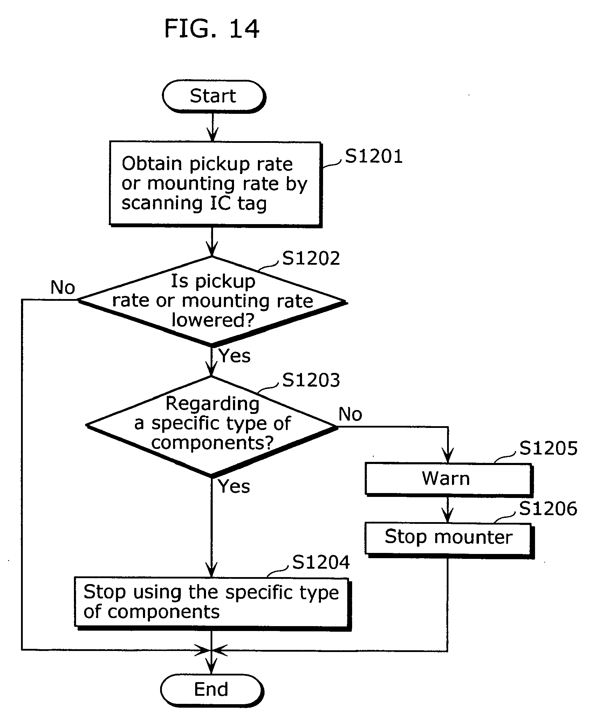

FIG. 14 is a flowchart showing processing performed by the mounter 100 of the first embodiment to perform maintenance management for a device using the information regarding quality management.

Firstly, the RF-tag reader/writer 111 scans and reads a RF tag 400 of a device, such as the nozzle 301, in order to read a pickup rate and a mounting rate which are the quality management information recorded during production until the present time (S1201).

Next, the determination unit 608 determines whether or not the pickup rate or the mounting rate has been lowered (S1202). More specifically, the determining whether or not the pickup rate (or mounting rate) has been lowered is performed by calculating a current pickup rate from the number of pickups and the number of pickup errors obtained during mounting (or calculating a current mounting rate from the number of mountings and the number of mounting errors), then comparing the calculated current pickiup rate (or mounting rate) to the pickup rate (or mounting rate) read out from the RF tag 400. Note that this determining may be performed after whole mounting is complete or every time each task is complete. Then, using the quality management information, the determination unit 608 determines whether or not the using nozzle 301 or component cassette 114 reaches maintenance timing (S1202). For example, if the current pickup rate of the using nozzle 301 is lower than the pickup rate recorded in the RF tag 400 which is past maintenance information of the nozzle 301, and the lowering degree exceeds a predetermined range, then it is determined that the nozzle 301 reaches maintenance timing. Moreover, if the pickup rate or the mounting rate is lowered (Yes at S1202), then the determination unit 608 further determines whether or not the pickup rate or the mounting rate is lowered regarding a specific type of electronic components (S1203). Here, if the pickup rate nor the mounting rate is not lowered (No at S1202), then the processing is terminated.

As a result of the determining, if the determination is made that the pickup rate or the like is lowered regarding a specific type of electronic components (Yes at S1203), then use of the device (component cassette, for example) corresponding to the specific component type is stopped (S1204).

On the other hand, if the determination is made that the pickup rate is lowered not regarding a specific type of electronic components, but regarding all types or plural types of electronic components (No at S1203), then the determination unit 608 controls the warning unit 609 to present a yellow signal when a use limit has not yet reached, and to present a red warning when the use limit has already been reached (S1205), and the driving of the mounter 100 is stopped (S1206). Thereby, maintenance necessity is determined for each component type, so that, if a trouble is related to a specific type of electronic components, the mounting can be kept by stopping use of only the component type.

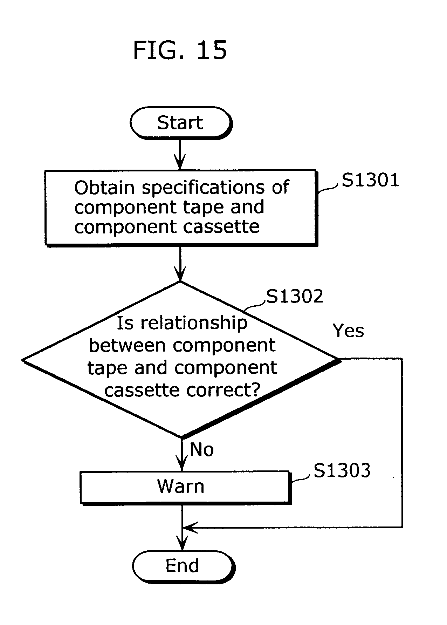

FIG. 15 is a flowchart showing processing performed by the mounter 100 of the first embodiment to check setup relationships between component tapes and the component cassettes 114.

Firstly, the RF-tag reader/writer 111 specifies a component tape and the component cassette 114 arranged in the same Z number using positions of RF tags 400, then obtains a specification of the component cassette from a RF tag 400 attached to the specified component cassette, and also obtains a specification of the component tape from a RF tag 400 attached to the specified component tape (S1301).

Next, the determination unit 608 determines whether or not a relationship between the setting component tape and the component cassette is correct, by referring to the information obtained by the RF-tag reader/writer 111 and maintenance information stored in the maintenance reference information storage unit 605, for example, material of the tape, such as paper or emboss, a tape width, a feed pitch, and the like (S1302). For example, the determination is made so as to whether or not a relationship between the component cassette specification obtained from a RF tag 400 attached to the component cassette and the component tape specification obtained from a RF tag 400 attached to the component tape set in the component cassette is the same as a relationship (allowable relationship between a component cassette specification and a component tape specification) indicated in the maintenance reference information stored in the maintenance reference information storage unit 605.

Then, if the determination is made that the relationship between the component tape and the component cassette is correct (Yes at S1302), then the determination unit 608 determines that the mounting is to be kept. On the other hand, if the determination is made that the relationship between the component tape and the component cassette is not correct (No at S1302), then the determination unit 608 instructs the warning unit 609 to present the red warning or the like (S1303). Thereby, it is checked whether or not each component tape is set in a correct component cassette, prior to starting of mounting.

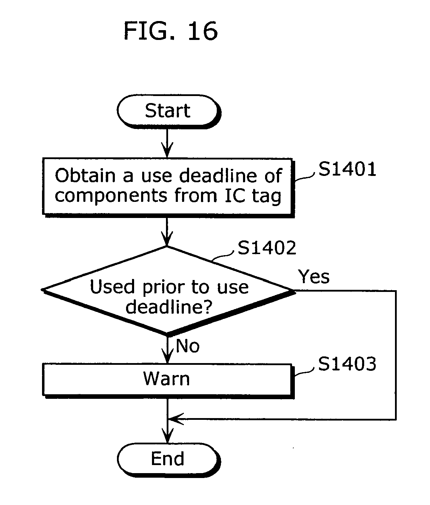

FIG. 16 is a flowchart showing processing performed by the mounter 100 of the first embodiment to perform management of deadline of using electronic components.

Firstly, the RF-tag reader/writer 111 obtains information regarding a use deadline from a RF tag 400 attached to the component tape 402 (S1401). Next, the determination unit 608 determines whether or not the electronic components are being used prior to the use deadline (S1402). This determining is performed by checking whether or not a current date/time obtained from a calendar timer in the mounter expires the use deadline recorded in the RF tag of the component tape 402.

Then, if the determination is made that the use is not prior to the use deadline (No at S1402), then it is determined that maintenance is necessary, and the warning unit 609 is instructed to display warning in setting the components into the component cassette 114 or during driving the mounter (S1403). Note that the warning may be yellow warning for components close to the use deadline and red warning for components expiring the use deadline.

On the other hand, if the determination is made that use is before the use deadline (Yes at S1402), then the processing is terminated.

Thereby, it is possible to prevent that some components are used even after use deadlines, so that the quality of produced boards is ensured. Note that one example of the component use deadline is September 10, 2006, or the like.

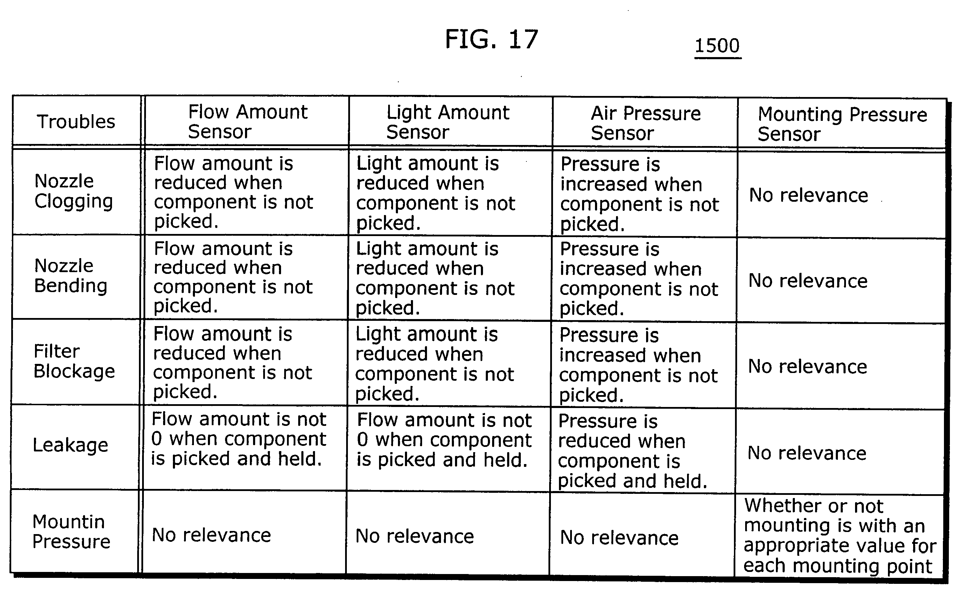

FIG. 17 is a table 1500 showing corresponding relationships between troubled portions in the nozzle 301 and detection details of various kinds of sensors, according to the first embodiment.

The troubles in the nozzle 301 are nozzle clogging, nozzle bending, filter blockage, leakage, and the like. In the mounter 100 according to the present invention, the nozzle 301 has one or more sensors, such as a flow amount sensor, a light amount sensor, an air pressure sensor, a mounting pressure sensor, and the like, in order to monitor respective problems. When a disorder is discovered, the yellow warning or the red warning is executed.

Then, the RF-tag reader/writer 111 of the mounter 100 has the RF tag 400 hold values measured by the sensors during driving and compares the measured values over time. Thereby, as shown in the table 1500, when a detected value of the flow amount sensor or the light amount sensor is decreased, nozzle clogging, nozzle bending, filter blockage, and the like can be monitored, and when a detected value of the air pressure sensor is increased, nozzle clogging, nozzle bending, filter blockage, and the like can be monitored.

Further, when a detected value of the flow amount sensor or the light amount sensor is not 0 during picking and holding components, occurrence of leakage is detected, while when a detected value of the air pressure sensor is decreased during holding components, occurrence of leakage is detected. Furthermore, using the mounting pressure sensor, it is possible to monitor whether or not a mounting pressure on each mounting point where an electronic component is mounted onto a board is within an appropriate value range.

As described above, in the mounter 100 according to the first embodiment, positions of RF tags 400 of a plurality of devices, such as the nozzle 301, can be determined using the RF-tag reader/writer 111 in order to collectively obtain maintenance information of respective parts in each device, which makes it possible to manage the device position information and the maintenance information read from each RF tag in association with each other, and also to obtain the component information easily preventing a complicated structure of the mounter.

Furthermore, the RF tag 400, in which maintenance information of respective parts are able to be recorded and updated, is attached to a device such as the nozzle 301, and the determination unit 608 compares the maintenance information which is obtained by the RF-tag reader/writer 111, to maintenance reference information, such as the number of usable times, which is stored in the maintenance reference information storage unit 605, which makes it possible to quantitatively determine maintenance necessity, for example whether or not it is a maintenance timing, regarding each device or each part in the device.

Still further, the management using the RF tags 400 results in a great amount of information stored in the built-in memory, which makes it possible to manage the maintenance information, not for each device but for more detailed unit, such as each part in the device.

Still further, the RF-tag reader/writer 111 updates and records the maintenance information in the RF tag 400 attached to the device, as needed after completion of component mounting, which makes it possible to perform maintenance according to more accurate maintenance information.

Note that the first embodiment has been described using the RF tags 400 as storage units, but besides the RF tags 400, it is also possible to use a two-dimensional barcode, a memory, and the like, which the RF-tag reader/writer 111 can read (or, read and write). Note also that the devices in the mounter using the maintenance method according to the present invention are not limited to the component cassette 114 and the nozzle 301, but, obviously, the same maintenance method can be used for other various kinds of devices, such as a pickup head and a tape cassette.

Note also that, in the first embodiment, the management apparatus 600 has been described as a hardware different from the mounter, but the present invention is not limited to such a structure. The management apparatus 600 may be built in the mounter or may be realized as software or hardware as one of the functions in the mounter.

### (Second Embodiment)

Next, a component mounting system according to the second embodiment according to the present invention is described.

### (Component Stock Management System)

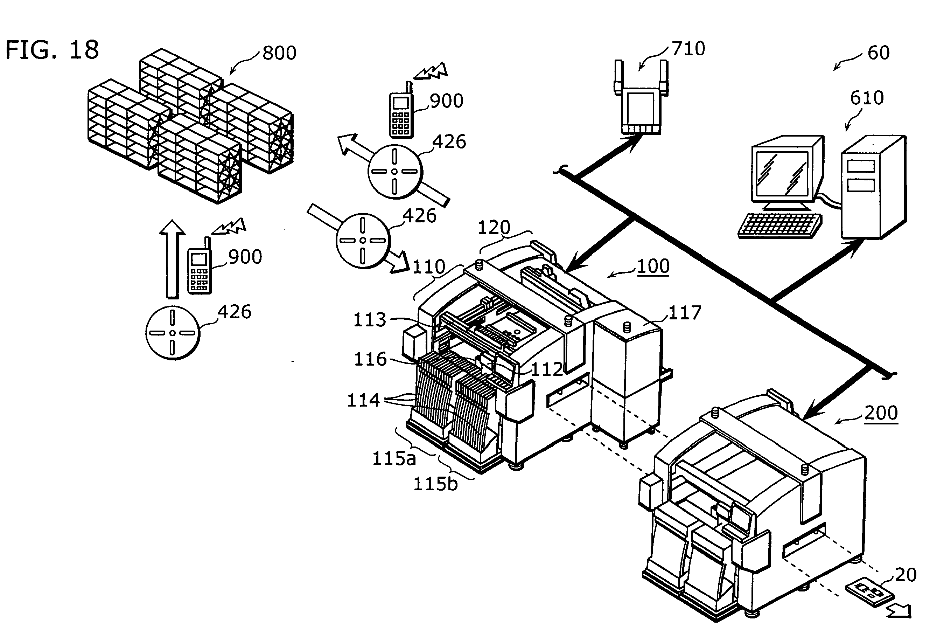

FIG. 18 is an external view showing an overall structure of a component mounting system 60 according to the second embodiment of the present invention. The component mounting system 60 is a system for mounting components onto a board 20. The component mounting system 60 includes component mounters (mounters) 100 and 200, a component stock management apparatus 610, a handy reader/writer 900, a radio repeater 710, and a component tape cabinet 800.

The plurality of mounters 100 and 200 structure a production line for sequentially mounting electronic components on a board being transported from the upstream to the downstream. The component stock management apparatus 610 is an apparatus which manages stocks of components to be mounted by the mounter 100 (200) onto the board 20. The handy reader/writer 900 is an apparatus for reading information from a RF tag attached to a component tape and writing information into the RF tag. A size of the handy reader/writer 900 is portable by the user. The radio repeater 710 is an apparatus for relaying radio data communication between the handy reader/writer 900 and the component stock management apparatus 610. The component tape cabinet 800 has shelves for holding respective supply reels 426 around which respective component tapes are wound. To each shelf in the component tape cabinet 800, a number (hereinafter, referred to as "shelf number") is assigned. The mounter 100 (200), the component stock management apparatus 610, and the radio repeater 710 are connected with one another via a Local Area Network (LAN).

The mounter 100 (200) is equipped with two stages (a front stage 110 and a rear stage 120) that perform component mounting simultaneously and independently of one another, or in concert, or even alternately. Each of these stages 110 and 120 is a perpendicular robotic mounting stage and includes two component supply units 115a and 115b, a line gang pickup head 112, an XY robot 113, a component recognition camera 116, and a tray supply unit 117. The component supply units 115a and 115b are each made up of an array of up to 48 component cassettes 114 that store component tapes. The line gang pickup head (ten-nozzle head) 112 has 10 pickup nozzles (hereafter simply "nozzles") that can pick up a maximum of 10 components from the component cassettes 114 and mount them onto the circuit board 20. The XY robot 113 moves the line gang pickup head 112. The component recognision camera 116 investigates the picked-up state of the components that have been picked up by the line gang pickup head 112 in two or three dimensions. The tray supply unit 117 supplies trays storing components. Each of these stages performs component mounting onto a board, independently of one another, in other words, in parallel.

In more detail, the mounter 100 is a mounting apparatus that includes the functions of both a mounting apparatus commonly called a high-speed mounter and a mounting apparatus called a multi-function mounter. A high-speed mounter is an apparatus characterized in high productivity of mounting electronic components that are 10 mm² or smaller in around 0.1 seconds, while a multi-function mounter is an apparatus that can mount large electronic components that are 10 mm² or larger, irregularly shaped components like switches and connectors, and IC components like Quad Flat Package (QFP) or Ball Grid Array (BGA) components

In short, the mounter 100 is designed so as to be able to mount almost all types of electronic components (from 0.6 mm by 0.3 mm chip resistors to 200 mm connectors, as mountable components), with a production line being formed by arranging the required number of mounters 100 in a line.

### (Structure of Mouner)

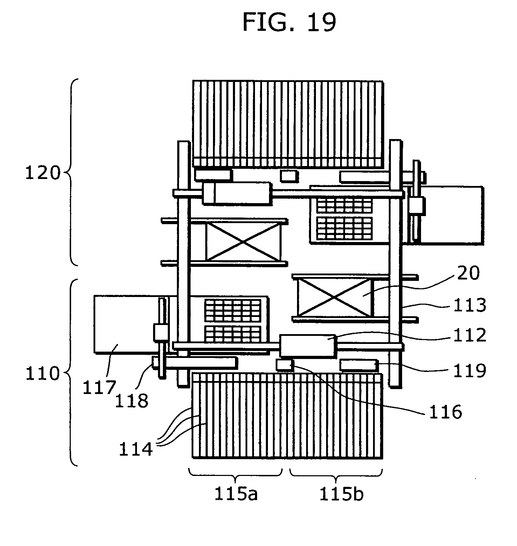

FIG. 19 is a plan view showing a main structure of the mounter 100 according to the present invention. Note that the mounter 200 has the same structure.

A shuttle conveyor 118 is a moving table (a component transportation conveyor) on which a component taken from the tray supply unit 117 is placed and which is moved to a predetermined position where the line gang pickup head 112 can pick up components from the shuttle conveyor 118. A nozzle station 119 is a table on which interchangeable nozzles corresponding to various sizes of components are positioned.

The component supply units 115a and 115b included in each stage 110 or 120 are provided on the left and right sides of the component recognition camera 116. The line gang pickup head 112 picks up components from the component supply unit 115a or 115b, passes by the component recognition camera 116, and then repeats an operation whereby the line gang pickup head 112 moves to a mounting point on the board 20 and sequentially mounts all of the picked-up components. The "mounting point" is a coordinate point on the board on which a component is to be mounted. The same type components are sometimes mounted on different mounting points. A total number of components (mounting points) arranged in a component tape regarding to the same component type is equivalent to the number of components of the component type (total number of components to be mounted).

Note that, in this description, one iteration of the repeated series of processes where the line gang pickup head 112 picks up, transports, and mounts components and the group of components handled in such iteration are both referred to as a "task". As one example, in the case of the ten-nozzle head (line gang pickup head 112), the maximum number of components that can be mounted by a single task is ten. It should also be noted that a "pickup operation" refers to all of the operations performed from when the head starts to pick up components to when the line gang pickup head 112 transports the components. In this description, a pickup operation refers not only to when ten components are picked up by the line gang pickup head 112 with a single nozzle stroke (a raising and lowering of the line gang pickup head 112), but also when ten components are picked using several nozzle strokes.

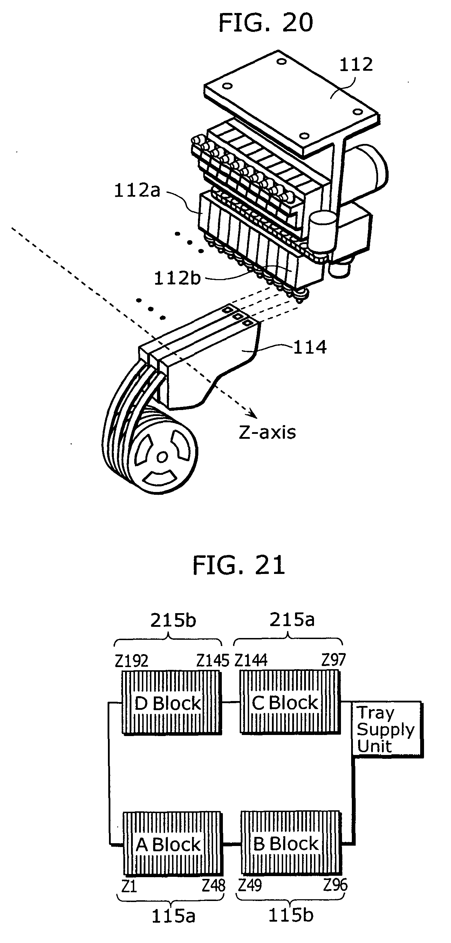

FIG. 20 is a diagram showing positional relationships between the line gang pickup heads 112 and component cassettes 114. The line gang pickup head 112 is an operation head using a method referred to as "gang pickup" and can be equipped with a maximum of ten pickup nozzles 112a to 112b. Here, the components can be simultaneously picked up from a maximum of ten component cassettes 114, respectively, in one raising and lowering of the line gang pickup head 112.

Note that a "single-cassette" component cassette 114 stores only one component tape, while a "double-cassette" component cassette 114 stores two component tapes. The position of each component cassette 114 (or component tape) in a component supply unit 115a or 115b is indicated using a "value in the Z-axis" or a "position on the Z-axis", with serial numbers or the like being assigned to positions starting with the leftmost position in the component supply unit 115a as position "1". As a result, the determination of mounting order for taped components amounts to the determination of the ordering (i.e., positioning on the Z-axis) of components (or component tapes, or component cassettes 114 in which the component tapes have been loaded). The "Z-axis" is a coordinate axis (or coordinate values on the axis) determining positions in ordering of component cassettes equipped in each mounter (or stage, if any).

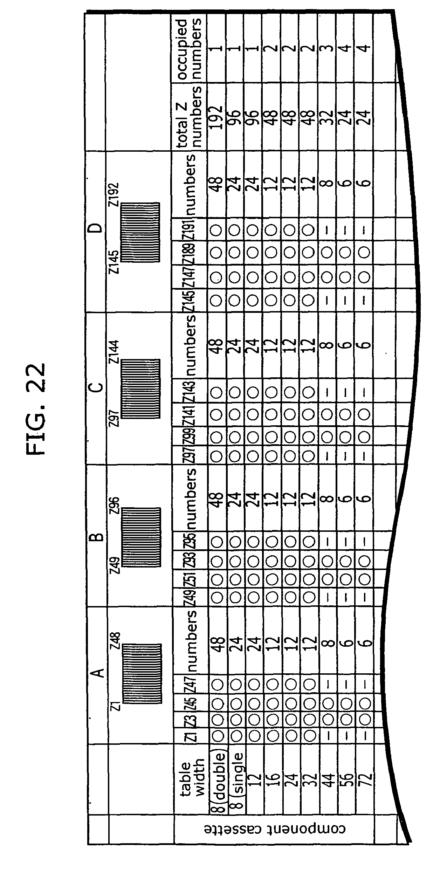

As shown in FIG. 21, the component supply units 115a, 115b, 215a, and 215b are each capable of storing a maximum of 48 component tapes, with the positions in these component supply units being respectively numbered Z1 to Z48, Z49 to Z96, Z97 to Z144, and Z145 to Z192. More specifically, as shown in FIG. 22, by using double-cassette cassettes that can store two 8 mm-wide component tapes, each component supply unit (A block to D block) can supply a maximum of 48 types of components. The wider the component tapes (component cassettes) used in a component supply unit, the lower the number of cassettes that can be loaded into a single block.

Note that in this description, the leftmost component supply units 115a and 215a (Block A and Block C) in each stage are referred to as the "left blocks", while the leftmost component supply units 115b and 215b (Block B and Block D) in each stage are referred to as the "right blocks".

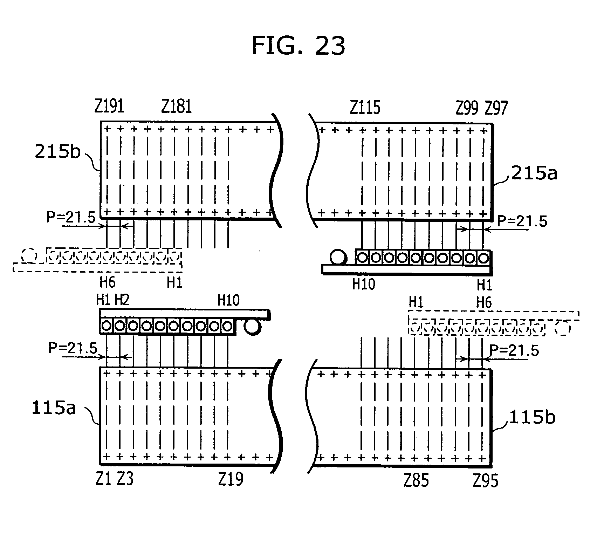

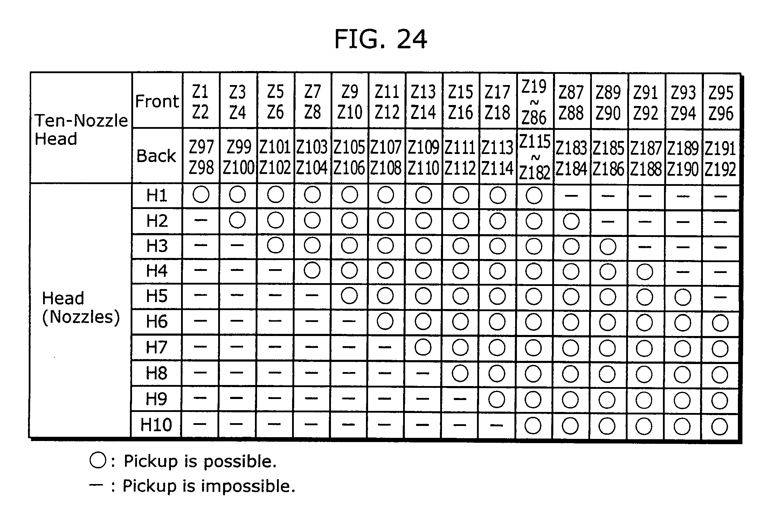

FIGS. 23 and 24 are a diagram and a table showing examples of positions in the Z-axis of component supply units where components can be picked up by a ten-nozzle head. Note that the values given as H1 to H10 in these drawings represent the positions of the 10 nozzles.

The intervals between the nozzles in the ten-nozzle head are equivalent to the width (21.5 mm) of one double-cassette cassette, so that the Z numbers of the components that can be picked up in a single nozzle stroke are two numbers apart (i.e., either all odd or all even). Due to the restrictions on the movement of the ten-nozzle head in the Z-axis, there are cases where certain nozzles are incapable of picking up components positioned near the ends of the component supply units. Such cases are indicated by the "-" marks in FIG. 24.

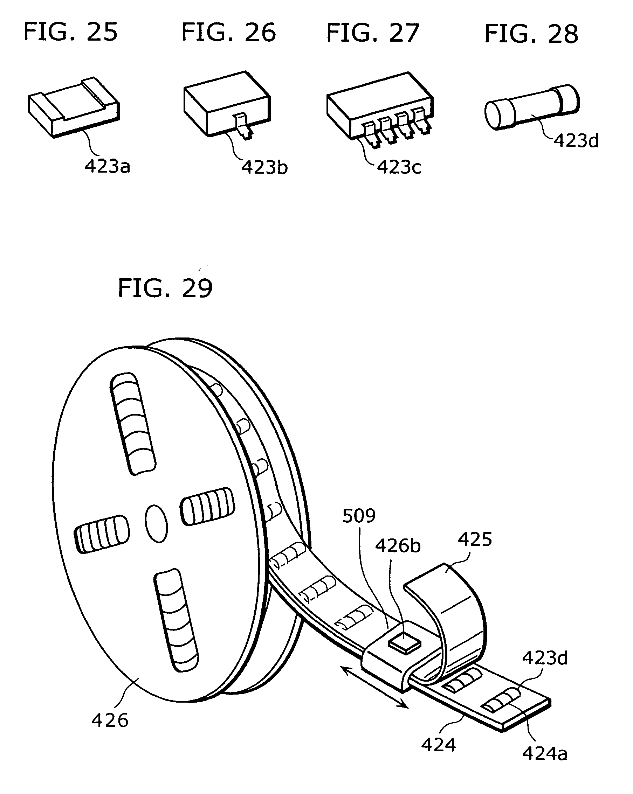

The following describes the structure of the component cassette 114 in detail, with reference to FIGS. 25 to 30.
FIGS. 25 to 28 show various chip-shaped electronic components 423a to 423d. As shown in FIG. 29, the components are placed into storage concaves 424a successively formed in a carrier tape 424 with predetermined intervals and are encapsulated by applying a cover tape 425 over the carrier tape 424. This carrier tape 424 is wound around the supply reel 426 with a predetermined length, and supplied to users as a component tape. Note that the shape of the space storing components is not limited to the concave shape.

As shown in FIG. 29, a slide member 509 made of resin molding or the like is equipped to the component tape and is able to be slid along the carrier tape. A RF tag 426b is attached on the slide member 509.

The RF tag 426b attached as above always stays at a certain position in the mounter 100 or 200, even if the component tape is sequentially pulled out for component mounting. For example, since the slide member 509 is locked at a predetermined position in the mounter 100 or 200, the slide member 509 is slid along the sequentially pulled component tape, staying at a certain position.

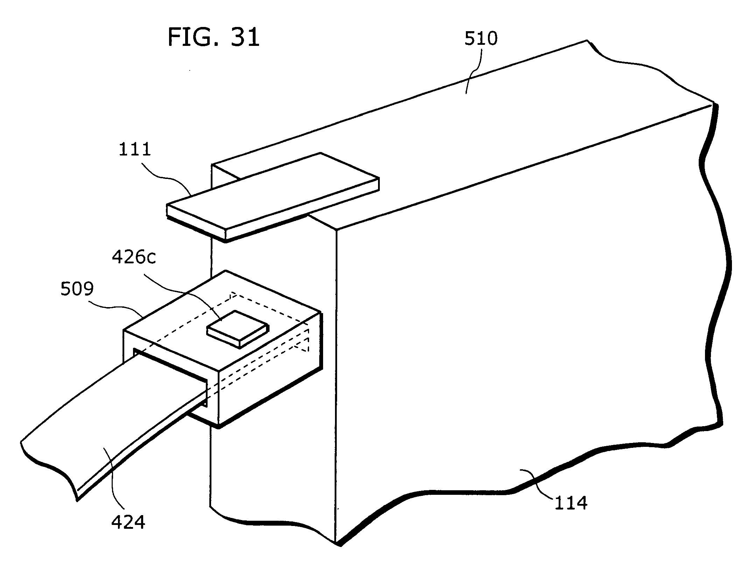

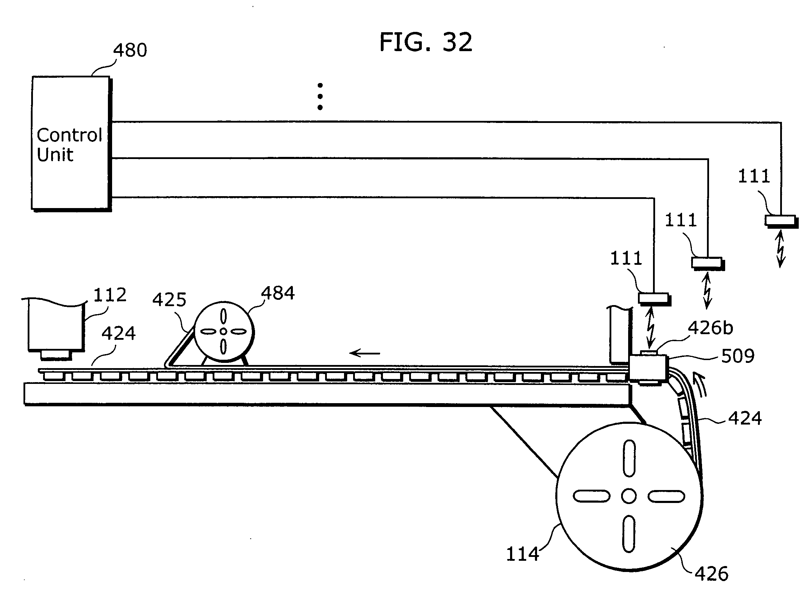

As a result, the RF-tag reader/writer 111 (as shown in FIGS. 31 and 32) on the mounter 100 or 200 can read component information from the RF tag 426b at the component tape, even during component mounting.

Further, using the RF-tag reader/writer 111, the mounter 100 or 200 can write the remaining component numbers of the electronic components 423d included in the component tape, into the RF tag 426b. Thereby, even if the currently using component tap in the supply reel 426 is taken out from the mounter 100 or 200 together with the supply reel 426, the slide member 509 is equipped to the component tape and the RF tag 426b attached to the slide member 509 holds the remaining compoennt numbers of the electronic components 423d. As a result, the user can surely manage the electronic components 423d, without re-calculating the remaining component numbers of the components 423d included in the component tape taken out during the mounting.

The RF tag 426b stores: manufacture information, such as a component name, a manufacturing number, the number of components, a manufacturer name, a manufacturing plant name, manufacturing data and time, a lot number, a serial number, and the like, regarding the taped components; information, such as a component size, a width of a component cassette 114 storing the carrier tape 424, a pitch interval of the storage concaves 424a, and the like; freshness information, such as a manufacturing date of the taped components, a use starting date written in opening the taped components, and the like; allowable temperature limit information for solder welding processing in a reflow furnace; and the like. Note that the carrier tape 424 may be an adhesive tape or a paper tape on which components are stick, besides the tape as shown in FIG. 29.

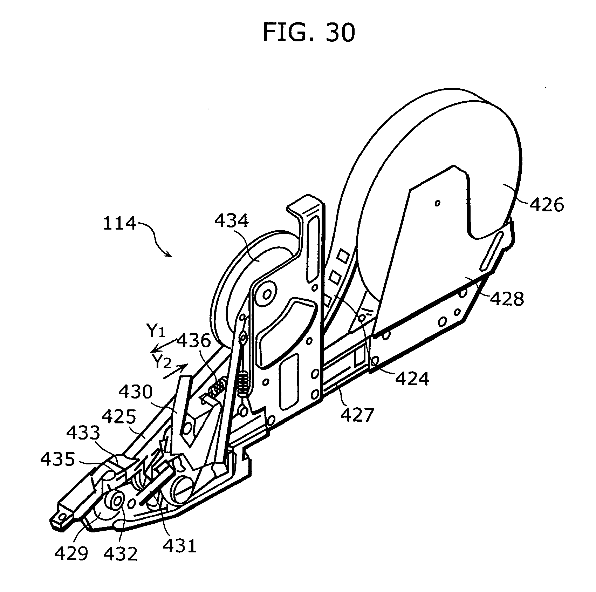

Such taped components 423d are used having first been loaded into a component cassette 114 as shown in FIG. 30. In FIG. 30, the supply reel 426 is attached to reel side plates 428 so as to be freely rotatable, with the reel side plates 428 engaging a main frame 427. The carrier tape 424 that has been pulled off the supply reel 426 is guided by a feed roller 429. An automatic electronic component mounting apparatus (not shown) in which this electronic component supply apparatus has been fitted operates as follows. Movement of a feed lever (not shown) also fitted in the apparatus causes a feed lever 430 of the electronic component supply apparatus to move in the direction shown as Y1 in FIG. 30. This movement is transmitted via a link 431 and results in a ratchet 432 rotating by a predetermined angle. Then, the feed roller 429 is disposed so as to move in conjuncture with the ratchet 432, and so moves by a predetermined pitch, such as a feed pitch of 2 mm or 4 mm. Note that the carrier tape 424 may be feed by motor driving or cylinder driving.

The cover tape 425 is peeled off by a cover tape separating unit 433 that is positioned before the feed roller 429 (towards the supply reel 426). The separated cover tape 425 is wound around a cover tape collecting reel 434 and the carrier tape 424 from which the cover tape 425 has been removed is transported to the electronic component removing unit 435. At the same time as the carrier tape 424 is fed by the feed roller 429, the electronic component removing unit 435 opens in conjunction with the movement of the ratchet 432, and a vacuum suction head (not shown) picks up a chip-shaped electronic component 423d using suction, thereby removing it from a storage space 424a. After this, the pressing force applied by the feed lever of the apparatus is removed and the force applied by a tension spring 436 causes the feed lever 430 to move in the direction shown as Y2. As a result, the feed lever 430 returns to its original position.

The above series of operations is repeated and the spent carrier tape 424 is discharged to the outside of the electronic component supply apparatus.

FIG. 31 is a view showing a positional relationship between the RF-tag reader/writer set in the component cassette and the RF tag on the slide member. A part of the component cassette 114 is covered with a cover 510, and the carrier tape 424 wound around the supply reel 426 goes into the cover 510 being pulled out from the supply reel 426. The RF-tag reader/writer 111 is equipped near the entrance of the cover 510. A height of the entrance of the cover 510 is designed to be lower than a height of the slide member 509. Thereby, when the carrier tape 424 goes into the cover 501, the slide member 509 always stays near the entrance of the cover 510. As a result, the RF-tag reader/writer 111 is stabilized to read information from the RF tag 426b attached to the slide member 509 and write information to the RF tag 426b.

FIG. 32 is a view for explaining a path along which electronic components stored in the carrier tape 424 wound around the supply reel 426 is transported to be pickup by the line gang pickup head 112.

The carrier tape 424 wound around the supply reel 426 moves to the left in FIG. 32, with the rotation of the supply reel 426. Here, as a top tape collecting reel 484 is rotated, the cover tape 425 is removed from the carrier tape 424. After removing the cover tape 425 from the carrier tape 424, the line gang pickup head 112 picks up the electronic components 423d from a carrier emboss tape 483 and mounts the components onto a board 20.

Note that the RF-tag reader/writer 111 is equipped for each component cassette 114. Note also that a control unit 480 controls the RF-tag reader/writer 111 of each component cassette 114 to read and write information. More specifically, the control unit 480 operates a certain RF-tag reader/writer 111, so that reading and writing of information are executed between the RF-tag reader/writer 111 and a RF tag 426b of a component tape corresponding to the RF-tag reader/writer 111. As a result, by the operation of the control unit 480, a position of the RF tag is easily determined.

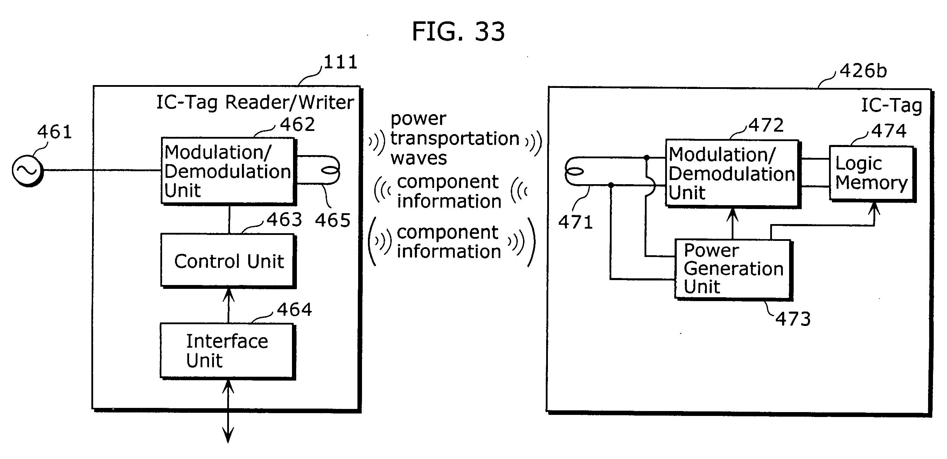

FIG. 33 is a diagram showing circuit structures of the FR-tag reader/writer 111 and the RF tag.

The RF-tag reader/writer 111 has a modulation/demodulation unit 462 connected to an alternating-current (AC) source 461, a control unit 463, an interface unit 464, and an antenna 465.

The modulation/demodulation unit 462 is a circuit for communicating with the RF tag 426b via the antenna 465. The modulation/demodulation unit 462 transmits power transportation waves to the RF tag 426b and receives component information from the RF tag 426b. More specifically, during receiving control codes outputted from the control unit 463, the modulation/demodulation unit 462 generates power transportation signals having a radio frequency (RF)of, for example, 13.56 MHz, and converts the signals into the power transportation waves to be transmitted via the antenna 465. Moreover, the modulation/demodulation unit 462 sends component information by the antenna 465, to be written into the RF tag 426b.

The control unit 463 controls the modulation/demodulation unit 462 to transmit or stop transmitting the power transportation waves and outputs the component information received from the modulation/demodulation unit 462 into the outside via the interface unit 464.

The RF tag 426b includes: an antenna 471, a modulation/demodulation unit 472, a power generation unit 473, and a logic memory 474. In the logic memory 474, the component information is stored.

The power generation unit 473 receives the power transportation waves from the RF-tag reader/writer 111 via the antenna 471 using an electromagnetic induction method or an electromagnetic coupling method, and then generates induced power having a high frequency. The power generation unit 473 commutates the induced power, smoothes a voltage of the commutated induced power to be a fixed value, and accumulates direct-current (DC) power, thereby supplying the generated DC power to the modulation/demodulation unit 472 and the logic memory 474, while the antenna 471 receives the power transportation waves.

The modulation/demodulation unit 472 converts the component information stored in the logic memory 474 into radio waves, and outputs the waves to the outside via the antenna 471. Note that the modulation method may be any methods, such as Amplitude Shift Keying (ASK) and Frequency-Shift Keying (FSK), as far as the methods conform to the demodulation method used in the modulation/demodulation unit 462 of the RF-tag reader/writer 111. The modulation/demodulation unit 472 demodulates the component information sent from the RF-tag reader/writer 111 and writes the resulting information into the logic memory 474.

The characteristic operations of the mounter 100 are as follows.

### (1) Nozzle Interchanging

When a nozzle that is required for the next mounting operation is not present on the line gang pickup head 112, the line gang pickup head 112 is moved to the nozzle station 119 where nozzle interchanging is performed. The types of nozzles available depend on the sizes of the components to be picked up by the line gang pickup head 112. As one example, "type S", "type M", and "type L" nozzles may be provided.

### (2) Component Pickup

The line gang pickup head 112 moves to the component supply units 115a and 115b and picks up electronic components using suction. When ten components cannot be simultaneously picked up, the line gang pickup head 112 may be repositioned and may make several nozzle strokes to pick up a maximum of ten electronic components.

### (3) Recognition Scan

The line gang pickup head 112 moves past the component recognition camera 116 at a predetermined speed. The component recognition camera 116 forms images of all of the electronic components that have been picked up by the line gang pickup head 112 and detects whether the components have been picked up at the correct positions.

### (4) Component Mounting

Electronic components are successively mounted on the circuit board 20.

The above operations (1) to (4) are repeated, thereby mounting all of the required electronic components onto the circuit board 20. The operations (2) to (4) form the main operation of the mounter 100 when mounting components and correspond to a "task". This means that a maximum of ten electronic components can be mounted on a board in a single task.

### (Line Gang Pickup Head)

The line gang pickup head 112 has ten mounting heads that can independently pick up and mount electronic components arranged in a line. A maximum of ten pickup nozzles can be attached, so that a maximum of ten components can be picked up in a single nozzle stroke by the line gang pickup head 112.

Each of the heads (a part capable of picking up one component) that compose the line gang pickup head 112 is referred to in this description as a "mounting head" or simply as a "head".

The ten mounting heads that form the line gang pickup head 112 are arranged in a straight line, which places a restriction on the movable range of the line gang pickup head 112, both when picking up components and when mounting components. In more detail, as shown in FIG. 24, there are restrictions as to which mounting heads are able to access components that are located at either end of a component supply unit (which is to say, near the left end of the left component supply unit 115a and near the right end of the right component supply unit 115b).

When mounting electronic components onto a board, there are also restrictions on the movable range of the line gang pickup head 112.

### (Component Recognition Camera)

As the component recognition camera 116, the mounter 100 is equipped with a 2D camera that forms two-dimensional images and a 3D camera that can also detect height. As the 2D camera, a 2DS camera and 2DL camera are provided for use, depending on the size of the area to be photographed. The 2DS camera is capable of photographing a small area at high speed, and is characterized by having maximum view field of 60 mm by 220 mm. The 3D camera is used to detect in three dimensions whether any of the leads of an IC component are bent.

The recognition scanning speed used when photographing electronic components differs depending on the camera being used. When components that are photographed by the 2DS camera and components that are photographed by the 3D camera are present in the same task, recognition scanning needs to be performed at the scanning speed of each camera, making two scanning operations necessary.

### (Component Supply Units)

Electronic components may be packaged in the form of a component tape, where components are held by a tape, or in the form of a tray in the form of a plate whose area is partitioned in keeping with the dimensions of components.

The supply of taped components is performed by the component supply units 115a and 115b, while the supply of tray components is performed by the tray supply unit 117.

The taping of electronic components is standardized, and tapes with widths of 8 mm to 72 mm are available for different-sized components. By setting components that are held by a tape (or in other words, a "component tape") in a component cassette (a "tape cassette unit") with a suitable width for the tape width, electronic components can be reliably and consecutively obtained from the tape.

The component supply units in which component cassettes are set are designed so that component tapes with a width of up to 12 mm can be loaded with no gaps at a pitch of 21.5 mm. When the width of the tape is 16 mm or above, tapes need to be set leaving an appropriate gap that depends on the width of the tape. In order to pick up a plurality of electronic components simultaneously (i.e., in a single nozzle stroke for the line gang pickup head 112), the mounting heads and component cassettes should be aligned with the same pitch. When each component is supplied using a tape that is 12 mm wide or narrower, ten components can be simultaneously picked up by the line gang pickup head 112.

Note that the two component supply units (the component supply unit 115a and the component supply unit 115b) that compose each component supply unit are each capable of holding a maximum of 48 tapes that are 12 mm wide or narrower.

### (Component Cassettes)

Component cassettes can be single-cassette cassettes that only hold one component tape or double-cassette cassettes that hold a maximum of two cassettes. The two component tapes that are placed in the same double-cassette cassette need to have the same feed pitch (2 mm or 4 mm).

### (Component Stock Management Apparatus)

The component stock management apparatus 610 is an apparatus which manages stocks of components to be used in component mounting.

More specifically, the component stock management apparatus 610 manages the number of components in a component tape stored in the component tape cabinet 800, a position of the component tape, and the like. Furthermore, the component stock management apparatus 610 manages whether or not the component tape is stored in the component tape cabinet 800, or is being used in the mounter 100.

### (Hardware Configuration of Component Stock Management Apparatus)

The component stock management apparatus 610 is realized when a general-purpose computer system, such as a personal computer, executes a stock management program according to the second embodiment of the present invention.

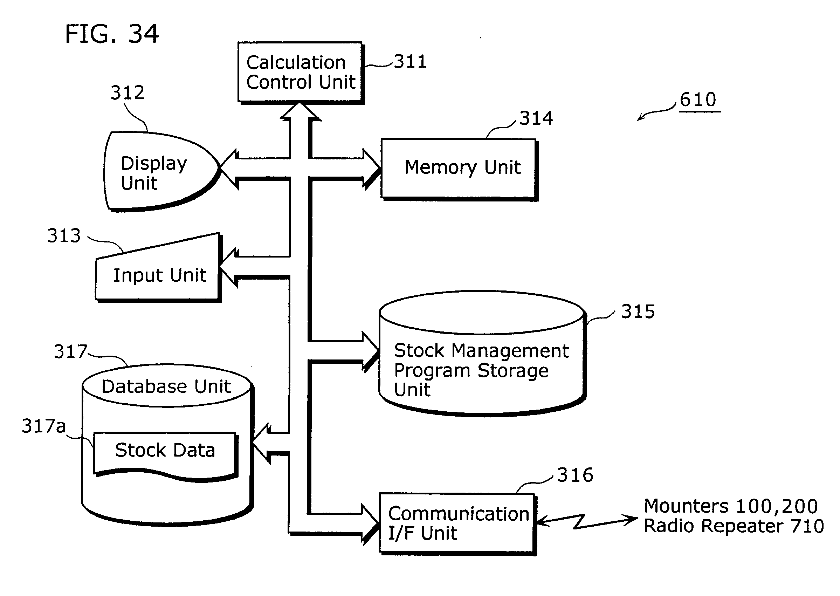

FIG. 34 is a block diagram showing a hardware configuration of the component stock management apparatus 610 shown in FIG. 18. This component stock management apparatus 610 includes: a calculation control unit 311, a display unit 312, an input unit 313, a memory unit 314, a stock management program storage unit 315, a communication interface (I/F) unit 316, a database unit 317, and the like.

The calculation control unit 311 is a Central Processing Unit (CPU), a numeric processor, or the like. The calculation control unit 311 loads the required programs from the stock management program storage unit 315 into the memory unit 314 and executes them. In accordance with the execution result, the calculation control unit 311 controls the units 312 to 317.

The display unit 312 is a Cathode Ray Tube (CRT), a Liquid Crystal Display (LCD), or the like, while the input unit 313 is a keyboard, a mouse, or the like. Under the control of the calculation control unit 311, these units are used to allow operator interaction with the component stock management apparatus 610.

The communication I/F unit 316 is a LAN adapter or the like, and is used to allow the component stock management apparatus 610 to communicate with the mounter 100 or 200 and the radio repeater 710, for example.

The memory unit 314 is a Random Access Memory (RAM) or the like that provides a working area for the calculation control unit 311. The stock management program storage unit 315 is a hard disk or the like, in which stock management programs for realizing the functions of the component stock management apparatus 610 are stored.

The database unit 317 is a hard disk or the like, storing stock data 317a generated in stock management of the component stock management apparatus 610.

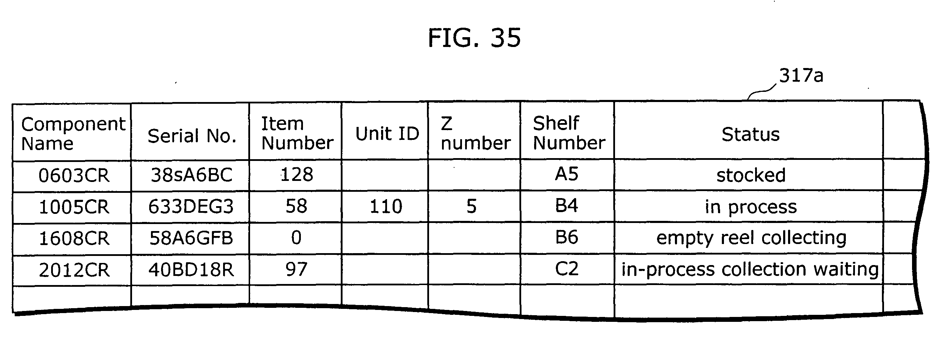

FIG. 35 is a table showing an example of the stock data 317a. The stock data 317a is data, in which information regarding stock of electronic components 423d to be mounted on the board 20 is indicated for each component tape storing the electronic components 423d. The stock data 317a includes: a component name of the taped components; the number of components and a serial number of the component tape; a mounter number (unit ID) of the mounter 100 (200) in which a component cassette 114 of the component tape is set; a position in the Z-axis (Z number) of the component cassette 114; a shelf number for determining a position of a shelf in the component tape cabinet 800 in which the component tape is stored; a status information indicating a status of the component cassette 114.

The status information indicates one of four kinds of information that are "stocked", "in process", "empty reel collecting", and "collection waiting". The "stocked" indicates a status where a component tape is stocked in the component tape cabinet 800. The "in process" indicates a status where the component tape is set in the mounter 100 (200) and the components in the tape are being mounted on the board 20. The "empty reel collecting" indicates a status where the taped components are run out so that a supply reel 426 around which the component tape is wound is to be collected. The "collection waiting" indicates a status where the mounter 100 completes mounting of the taped components so that the component tape is to be re-stocked into the original position of the component tape cabinet 800 in which the component tape has been stocked.

### (Z Number Identifying)

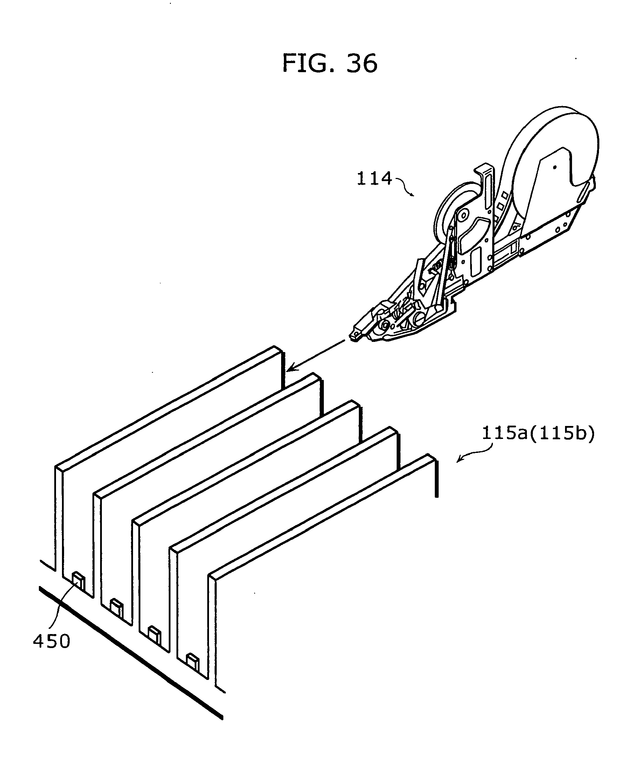

FIG. 36 is a view for explaining the component supply unit 115a or 115b in more detail. A switch 450 is arranged for each Z number in the component supply unit 115a or 115b. Outputs of the respective switches 450 are connected to the above-described control unit 480.

The switch 450 is electrically turned ON when the component cassette 114 is equipped in the component supply unit 115a (115b). Based on output from the switch 450, the mounter 100 determines the Z number where the component cassette 114 is equipped in the component supply unit 115a (115b).

### (Component Stock Management)

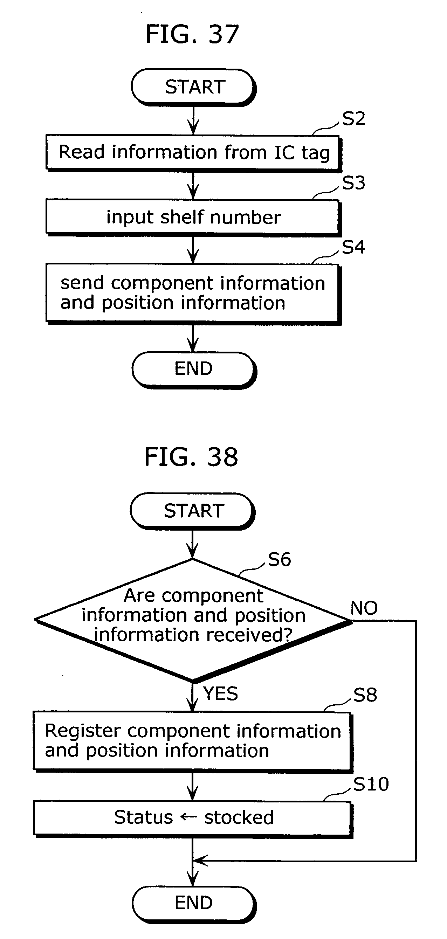

The following describes component stock management with reference to FIGS. 37 to 42. The component stock management has three kinds of processing which are processing in newly stocking, processing in component mounting, and processing in re-stocking. The processing in newly stocking is processing of managing a stock of components performed when a new component tape is stocked in the component tape cabinet 800. The processing in component mounting is processing of managing a stock of components performed from when the component tape is taken out from the component tape cabinet 800, then equipped in the mounter 100, until when the mounter 100 completes mounting of the components. The processing in re-stocking is processing of managing a stock of components performed from when the mounter completes the mounting, until when the component tape is re-stocked into the component tape cabinet 800. The following describes each of the processing in order.

### (Processing in Newly Stocking)

FIG. 37 is a flowchart of processing performed by a user when a component tape is newly stocked into the component tape cabinet 800. FIG. 38 is a flowchart of processing performed by the component stock management apparatus 610 when a component tape is newly stocked into the component tape cabinet 800.

As shown in FIG. 37, from a RF tag 426b of a component tape to be newly stocked, the user reads a component name of the taped components, and a serial number of the component tape and the number of components in the component tape, using the handy reader/writer 900 (S2). Furthermore, into the handy reader/writer 900, the user inputs a shelf number indicating a position of the shelf in the component tape cabinet 800, into which the component tape is to be stocked (S3). From the handy reader/writer 900 via the radio repeater 710, the user sends the component information read from the RF tag 426b and the position information (shelf number) inputted by the handy reader/writer 900 (S4).

As shown in FIG. 38, when the component stock management apparatus 610 receives the component information and the position information from the handy reader/writer 900 via the radio repeater 710 (Yes at S6), then the component stock management apparatus 610 registers them into the stock data 317a (S8). Moreover, the component stock management apparatus 610 sets status information regarding the registered information to "stocked" (S10). As a result of the above processing, data at the 1st line of the stock data 317a shown in FIG. 35 (data regarding component name "0603CR"), for example, is registered. Thereby, it is understood that the component tape specified by a component name "0603CR" and a serial number "33sA6BC" is stocked at a position of a shelf number "A5" in the component tape cabinet 800.

### (Processing in Component Mounting)

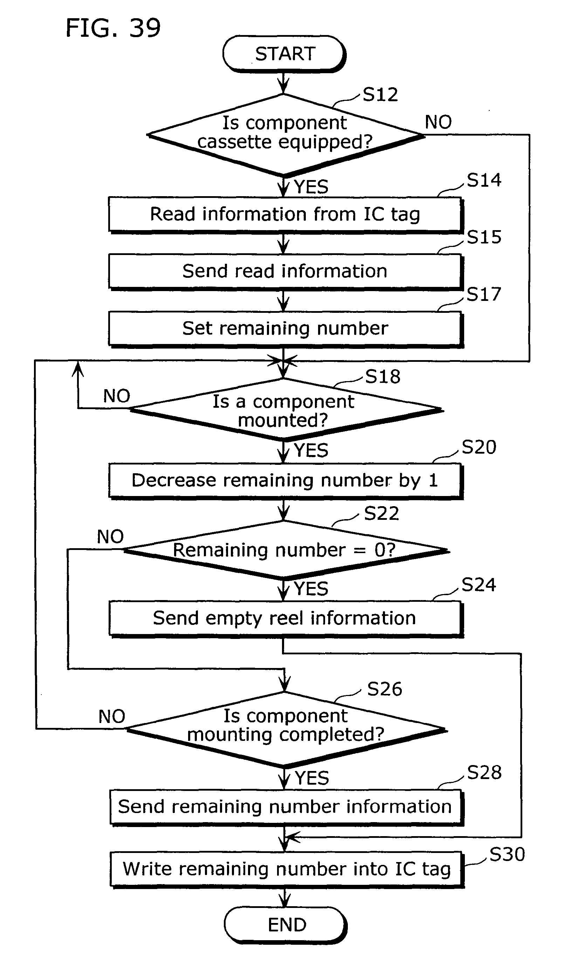

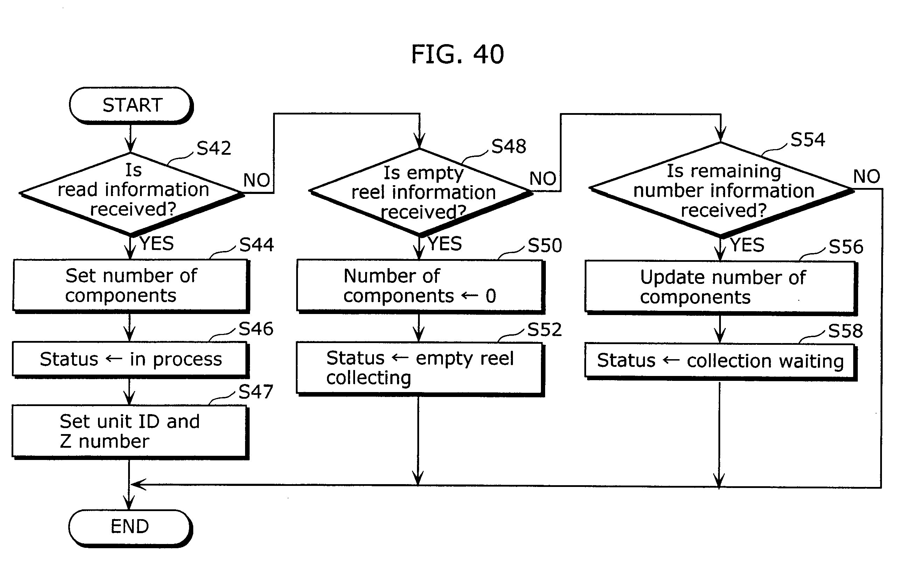

FIG. 39 is a flowchart of processing performed by the mounter 100 when the component tape is loaded in the mounter 100 and components in the tape are being mounted by the mounter 100. FIG. 40 is a flowchart of processing performed by the component stock management apparatus 610 when the component tape is loaded in the mounter 100.

As shown in FIG. 39, when the switch 450 detects setting of the component cassette 114 into the component supply unit 115a or 115b (YES at S12), then the control unit 480 controls the RF-tag reader/writer 111, which corresponds to a position of the set component cassette 114, to read information from the RF tag 426b attached to the component cassette at the position (S14). Here, a component name of the taped components and a serial number of the component tape and the number of taped components tape are read out. Note that, the step S14 is one example of processing performed by a "reading unit" recited in claims appended in the description. The mounter 100 sends the read information to the component stock management apparatus 610 (S15). Here, to the component stock management apparatus 610, the mounter 100 also sends a unit ID of the mounter in which the component cassette 114 is set, and a Z number of the component cassette 114.

Moreover, in the mounter 100, the number of the taped components is recorded as the number of remaining components (remaining number) into a memory not shown in the figure (S17). When a component is mounted on the board 20 (YES at S18), then mounter 100 decreases the remaining number recorded in the memory by 1 (S20). Note that, the step S20 is one example of processing performed by a "updating unit" recited in claims appended in the description. Based on the value recorded in the memory, the mounter 100 checks whether or not the remaining number is 0 (S22). When the remaining number becomes 0 (YES at S22), the mounter 100 sends empty reel information indicating that a reel around which the component tape is wound becomes empty, to the component stock management apparatus 610 (S24). Here, the mounter 100 also sends the component name and the serial number. After that, the mounter 100 writes the remaining number information, which is 0, into the RF tag 426b attached to the corresponding component tape (S30), and completes the processing.

If the remaining number of any component type is not 0 (NO at S22), then the mounter 100 determines whether or not the component mounting on the board 20 is complete. If the component mounting on the board 20 is complete (YES at S26), the mounter 100 sends remaining number information recorded in the memory into the component stock management apparatus 610 (S28), writes the remaining number information into each RF tag 426b of the corresponding component tape (S30), and ends the processing. Note that, when the remaining number information is sent, the component name and the serial number are also sent. The step S30 is one example of processing performed by a "writing unit" recited in claims appended in the description.

Note that, in the processing shown in FIG. 39, when the remaining number of taped components becomes 0 (YES at S22), then the mounter 100 completes the processing. However, in the case where another component tape in the component supply unit 115a or 115b stores the same type taped components, the following processing is also possible. More specifically, after the empty reel information is sent to the component stock management apparatus 610 (S24), the electronic components 423d are taken out from a component tape storing the same type taped components in order to continue the mounting of the electronic components 423d.

As shown in FIG. 40, when the mounter 100 receives the information read from the RF tag 426b of the component tape (YES at S42), then, based on the information, the component stock management apparatus 610 sets component number information regarding the stock data 317a (S44). After that, the status information in the stock data 317a is set to "in process" (S46). Moreover, the component stock management apparatus 610 sets the unit ID and the Z number in the stock data 317a (S47). In more detail, using the component name and the serial number as searching conditions, a corresponding line in the stock data 317a is selected, and the number of components, the status, the unit ID, and the Z number are set in the line. Here, it is assumed that the information read and sent by the mounter 100 are component name "1005CR", serial number "633DEG3", and the number of components "58", and that information sent together with such information are unit ID "110" and Z number "5". In this case, information is updated to be seen in the second line of the stock data 317a of FIG. 35. Thereby, it is understood that taped components in a component tape identified by the component name "1005CR" and the serial number "633DEG3" are being used in the mounter 100 identified by the unit ID "100", and that a Z number of a component supply unit 115a (115b) in which the taped components are stored is 5. It is also indicated that the number of the taped components at the start of the mounting is 58.

When the empty reel information is received from the mounter 100 (YES at S48), the component stock management apparatus 610 sets, in the stock data 317a, the number of components specified by the component name and the serial number included in the empty reel information to 0 (S50), and the status information to "empty reel collecting" (S52). For example, when component name "1608CR", serial number "58A6GFB", and the empty reel information are received from the mounter 100, information is updated to be seen in the third line of the stock data 317a of FIG. 35. Thereby, it is indicated that taped components in a component tape identified by the component name "1608CR" and serial number "58A6GFB" become empty, and that a supply reel 425 around which the component tape is wound is to be collected. Note that, in this timing, the component stock management apparatus 610 may determine that the reel is at maintenance timing, in other words, the reel needs to be interchanged, and then present warning for reel interchanging necessity via the display unit 312.

When the remaining number information is received from the mounter 100 (YES at S54), the component stock management apparatus 610 sets, in the stock data 317a, the number of components specified by the component name and the serial number included in the remaining number information to the received remaining number (S56), and the status information to "collection waiting" (S58). For example, when component name "2012CR", serial number "40BD18R", and the remaining number "97" are received from the mounter 100, information is updated to be seen in the fourth line of the stock data 317a of FIG. 35. Thereby, it is indicated that the number of components in a component tape identified by the component name "2012CR" and the serial number "40BD18R" is set ot "97", and that the component tape is to be stocked in the component tape cabinet 800.

### (Processing in Re-stocking)

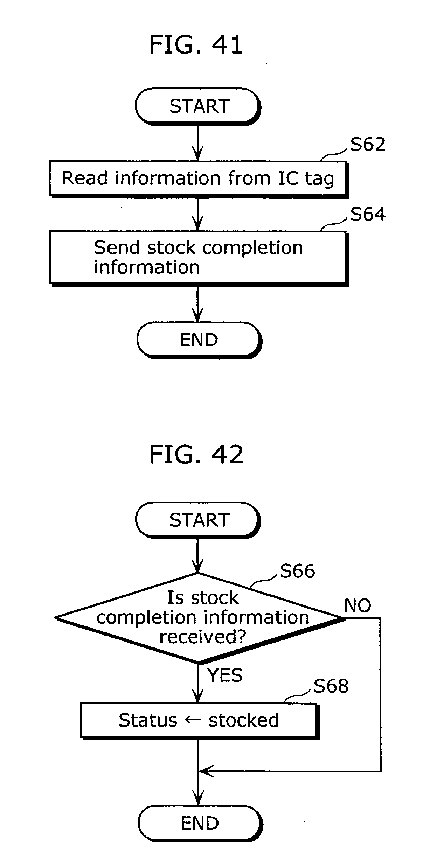

FIG. 41 is a flowchart of processing performed by a user when a component tape is re-stocked into the component tape cabinet 800. FIG. 42 is a flowchart of processing performed by the component stock management apparatus 610 when a component tape is re-stocked into the component tape shelf 800.

As shown in FIG. 41, after completing component mounting of the mounter 100, the user takes the supply reel 426 from the component supply unit 115a or 115b, and reads information from a RF tag 426b attached to the component tape, using the handy reader/writer 900 (S62). The read information is displayed by the handy reader/writer 900. Based on the information, the component tape is returned to a appropriate shelf position in the component tape cabinet 800. After completing the re-storing into the component tape cabinet 800, the user sends information indicating the re-stocking completion, to the component stock management apparatus 610 using the handy reader/writer 900 (S64). At the same time, the component name and the serial number are also sent.

As shown in FIG. 42, the component stock management apparatus 610 receives the information indicating the re-stocking completion (YES at S66), then the component stock management apparatus 610 sets, in the stock data 317a, the status information at the line specified by the component name and the serial number included in the information, to "stocked" (S68). For example, when component name "0603CR" and serial number "38sA6BC" are received as the information, information is updated to be seen in the first line of the stock data 317a of FIG. 35. Thereby, it is indicated that the status information of a component tape identified by the component name "0603CR" and the serial number "38sA6BC" is set to "stocked", and that the component tape is stocked in the component tape cabinet 800.

As described above, according to the second embodiment, in the RF tag 426b attached to the component tape, the component number information of the taped components is previously recorded. The mounter 100 reads the number of components from the RF tag 426 and writes the read component number information into the memory in the mounter. The reading of the information from the RF tag 426b is able to be performed using radio communication. Thereby, as compared to conventional reading of the component number information from barcodes using a barcode reader, the second embodiment can read the compoennt number information faster, without bothering reading procedures.

Furthermore, the component number information is written to the RF tag 426b of the component tape, when the mounter 100 completes the component mounting. Thereby, bothering procedures for re-applying the barcode reader is not necessary.

Still further, the number of components counted by the mounter 100 is written into the RF tag 426b. Thereby, even if there are remaining components in the component tape after mounting, it is not necessary to re-count the number of the remaining taped components, thereby eliminating bothering procedures.

Thus, although the component mounting system according to the second embodiment has been described, the present invention is not limited to the second embodiment.

For example, in the second embodiment, the RF tag 426b is arranged on the slide member 509 equipped in the component tape, but the position of the RF tag 426b is not limited to such a position. For example, the FR tag 426b may be arranged on the supply reel 426, or on a starting edge of the component tape.

Further, although the number of taped components is managed by stocking a component tape storing the components in the component tape cabinet 800, the number of the components may be managed by storing the components in a tray, a bulk, a stick, or the like, and stocking the stored components into the component tape cabinet 800. In such a case, the RF tag 426b is attached to the tray, the bulk, the stick, or the like.

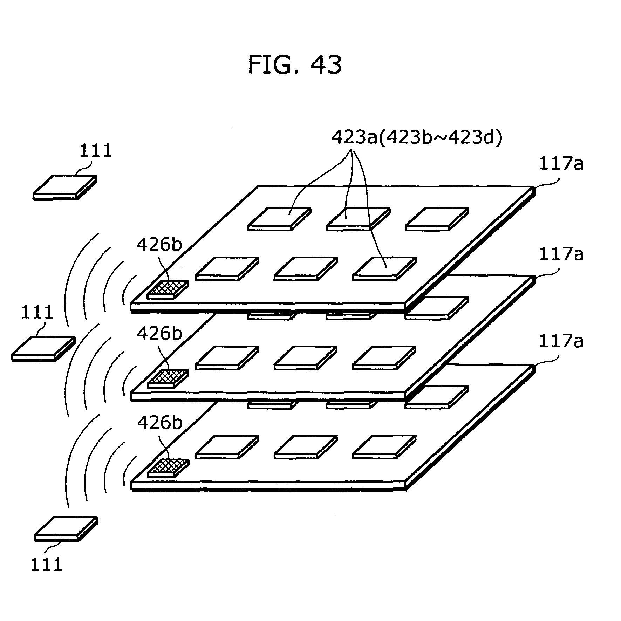

FIG. 43 is a view showing a situation where the RF tags are attached to trays. A tray 117a holds a group of electronic components 423a to 423d, arranging the components on a plane surface. The already-described tray supply unit 117 stores a plurality of the trays 117a, being sequentially stacked with gaps. The RF tags 426b is attached to each of the trays 117a. The RF tag reader/writer 111 is equipped for each of the trays 117a, in order to detect from which tray components are taken out.

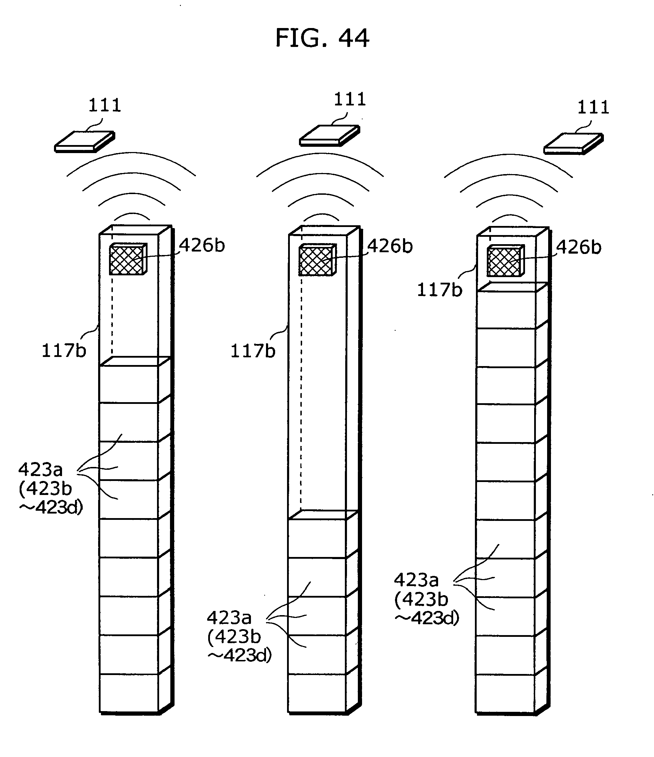

FIG. 44 is a view showing a situation where the RF tags are attached to sticks. A stick 117b is a long and thin container made of resin molding, for example. The stick 117b stores a group of electronic components 423 (any of 423a to 423d) being arranged in a line without a gap. A plurality of the sticks 117b are equipped in the mounters 100 and 200, being arranged in a line, upright in a longer direction along a vertical direction.

The RF tag 426b is attached to each of the sticks 117b. The RF tag reader/writer 111 is equipped for each of the sticks 117b, in order to detect from which stick 117b the electronic components 423 (one of 423a to 423d) are taken out.

Furthermore, even if components are lost from the component tape, the user can rewrite the component number in the stock data 317a, by inputting the number of lost components, using the input unit 313 of the component stock management apparatus 610. Here, the component stock management apparatus 610 sends the rewritten component number information to the mounter 100, so that the mounter 100 also holds the most recent component number information and after mounting the component number information is written into the RF tag 426b of the component tape. Thereby, accurate component number information is written into the RF tag 426b of the component tape.

Still further, although it has been described that the information is read from the RF tag 426b using the handy reader/writer 900 when the component tape is stocked into the component tape cabinet 800, it is also possible that a RF tag reader/writer is equipped in the component tape cabinet 800, the RF tag reader/writer automatically reads the information from the RF tag 426b, and the read information is displayed by the display unit.

### (Third Embodiment)

Next, a component mounting system according to the third embodiment of the present invention is described.

### (Mounting System)

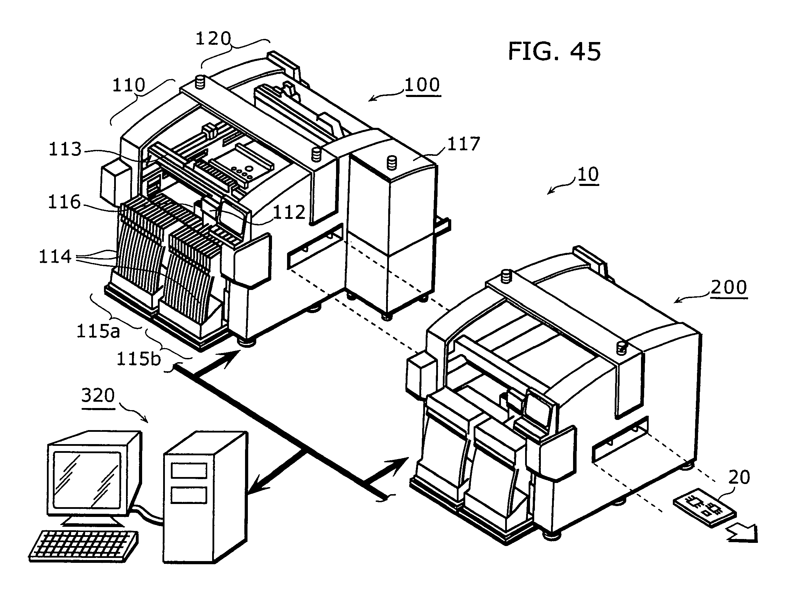

FIG. 45 is an external view showing an overall structure of a component mounting system 10 according to the present invention. The mounting system 10 is composed of a plurality of mounters 100 and 200 and a component number management apparatus 320. The mounters 100 and 200 form a production line where electronic components are mounted onto a circuit board 20 that is transported downstream. The component number management apparatus 320 optimizes the mounting order of the required electronic components at the start of production, for example, based on information in a variety of databases, sets and controls the mounters 100 and 200 having provided them with the Numeric Control (NC) data produced by the optimization, and manages the number of remaining components.

The mounter 100 is equipped with two stages (a front stage 110 and a rear stage 120) that operate simultaneously and independently of one another, or in concert, or even alternately. Each of these stages 110 and 120 is a perpendicular robotic mounting stage and includes two component supply units 115a and 115b, a line gang pickup head 112, an XY robot 113, a component recognition camera 116, a tray supply unit 117, and the like. The component supply units 115a and 115b are each made up of an array of up to 48 component cassettes 114 that store component tapes. The line gang pickup head (ten-nozzle head) 112 has 10 pickup nozzles (hereafter simply "nozzles") that can pick up a maximum of 10 components from the component cassettes 114 and mount them onto the circuit board 20. The XY robot 113 moves the line gang pickup head 112. The component recognision camera 116 investigates the picked-up state of the components that have been picked up by the line gang pickup head 112 in two or three dimensions. The tray supply unit 117 supplies tray storing components. Each of these stages performs component mounting onto a board, independently of one another, in other words, in parallel.

Here, the "component tape" is actually a tape (a carrier tape) on which a number of the same type of components have been arranged, with such tape being supplied from a reel (a supply reel) or the like around which the tape has been wound. Component tapes are usually used to supply relatively small components called "chip components" to a mounter. Note that the "component types" means types of components, such as a resistor, and a capacitor.

Note also that the components supplied by the component tape are also referred to as taped components.
In more detail, the mounter 100 is a mounting apparatus that includes the functions of both a mounting apparatus commonly called a high-speed mounter and a mounting apparatus called a multi-function mounter. A high-speed mounter is an apparatus characterized in high productivity of mounting electronic components that are 10 mm² or smaller in around 0.1 seconds, while a multi-function mounter is an apparatus that can mount large electronic components that are 10 mm² or larger, irregularly shaped components like switches and connectors, and IC components like Quad Flat Package (QFP) or Ball Grid Array (BGA) components

In short, the mounter 100 is designed so as to be able to mount almost all types of electronic components (from 0.6 mm by 0.3 mm chip resistors to 200 mm connectors, as mountable components), with a production line being formed by arranging the required number of mounters 100 in a line.

### (Structure of the Mouner)

The basic structure of the first embodiment is the same as the structure shown in FIG. 19.
Note that the positional relationship between the line gang pickup head 112 and the component cassette 114 is the same as shown in FIG. 20.

Note also that, as shown in FIG. 21, the component supply units 115a, 115b, 215a, and 215b are each capable of storing a maximum of 48 component tapes. More specifically, as shown in FIG. 22, by using double-cassette cassettes that can store two 8 mm-wide component tapes, each component supply unit (A block to D block) can supply a maximum of 48 types of components.

Note also that a diagram and a table showing examples of positions in the Z-axis of component supply units where components can be picked up by a ten-nozzle head are same as the diagram and the table shown in FIGS. 23 and 24.

The following describes the structure of the component cassette 114 in detail.

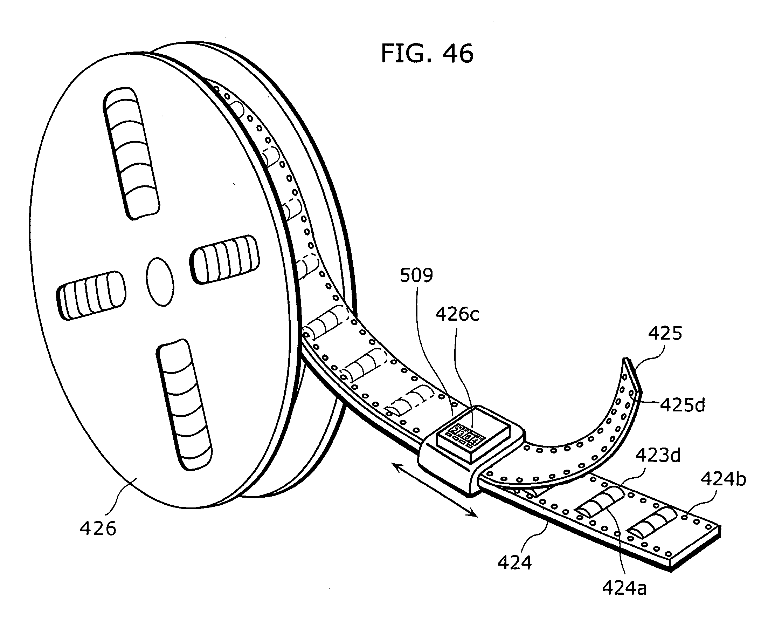

FIGS. 25 to 28 show various chip-shaped electronic components 423a to 423d. As shown in FIG. 46, the components are placed into storage concaves 424a successively formed in a carrier tape 424 with predetermined intervals and are encapsulated by applying a cover tape 425 over the carrier tape 424. This carrier tape 424 is wound around the supply reel 426 with a predetermined length, and supplied to users as a component tape. Note that the shape of the space storing components is not limited to the concave shape.

As shown in FIG. 46, a slide member 509 made of resin molding or the like is equipped to the component tape and is able to be slid along the carrier tape. A counter 426c for counting the number of taped components is attached on the slide member 509. Note that, as described further below, a Radio Frequency (RF) tag is embedded in the counter 426c.

The counter 426c attached as above always stays at a certain position in the mounter 100 or 200, even if the component tape is sequentially pulled out for component mounting. For example, since the slide member 509 is locked at a predetermined position in the mounter 100 or 200, the slide member 509 is slid along the sequentially pulled component tape, staying at a certain position.

As a result, a RF-tag reader/writer (not shown) on the mounter 100 or 200 can read the remaining number of components from the RF tag 426b embedded in the counter 426c, even during component mounting. On the carrier tape 424 storing components and the cover tape 425 over the carrier tape 424, plural holes 424b and plural holes 425b are formed with predetermined intervals. Each of the electronic components 423d is stored in each of storage concaves in the carrier tape 424. Note that the carrier tape 424 may be an adhesive tape or a paper tape on which components are stick, besides the tape as shown in FIG. 46.

Such taped components 423d are used being stored in the component cassette 114 as shown in FIG. 30.

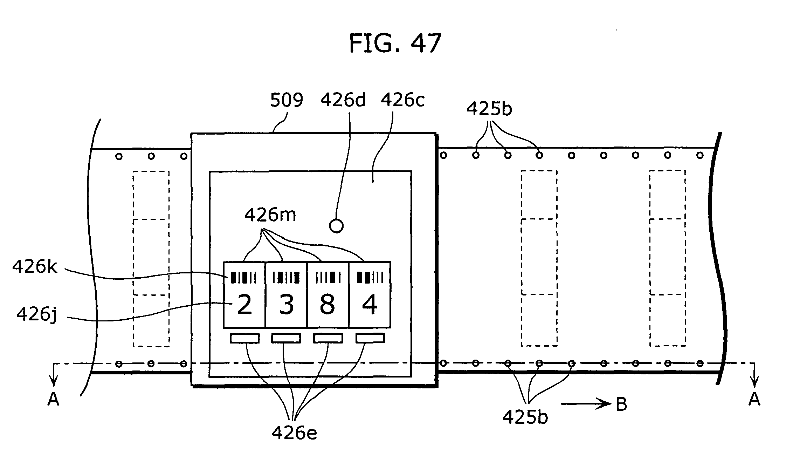

FIG. 47 is a top view of the slide member 509 of FIG. 46.

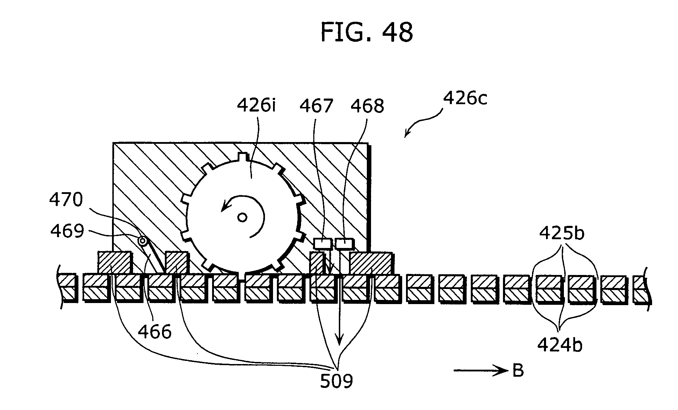

FIG. 48 is a cross sectional view taken along line A-A of the slide member 509 of FIG. 47.

As shown in FIGS. 47 and 48, the counter 426c is a device for counting the number of taped components. The counter 426 has a display unit 426m, a count-up switch 426e, a Light Emitting Diode (LED) 426d, and a gear 426i.

The gear 426i is arranged to be engaged with the holes 425b in the cover tape 425 and the holes 424b in the carrier tape 424, as shown in FIG. 48.

The display unit 426m is a display unit which displays the number of the taped components by four-digit numeral characters. Note that the number of digits is merely one example, and may be any number of digits.

Each of the digits in the display unit 426m is combination of a numeric value display 426j and a barcode display 426k. Note that in the barcode display 426k, each of the numeric values from 0 to 9 corresponds to each different barcode.

The count-up switch 426e is formed for each digit in the display unit 426m. Every pressing, a value of the digit corresponding to the count-up switch 426 is increased by 1. Note that a value "9" is increased by 1 to be "0".

The LED 426d blinks to urge the user to interchange the component tape, when the remaining number of components in the tape becomes equal to or less than a predetermined threshold value.

Further, as shown in FIG. 48, inside the counter 426c, there are the first light sensor 467, the second light sensor 468, and the dock sensor 469.

The first light sensor 467 and the second light sensor 468 are photoelectric sensors for detecting the holes 425b and 424b in the component tape, and arranged in parallel in a longer direction of the component tape.

The dock sensor 469 is a sensor having a rod-shaped knock pin 466 which is formed on an axis center 470 and capable of turning upon the axis center 470. The dock sensor 469 detects inclination of the knock pin 466. The knock pin 466 is inclined to the right when the component tape is pulled out in a direction shown by an arrow B in FIG. 48, while it is inclined to the left when the component tape is pulled back in a direction opposite to the arrow B.

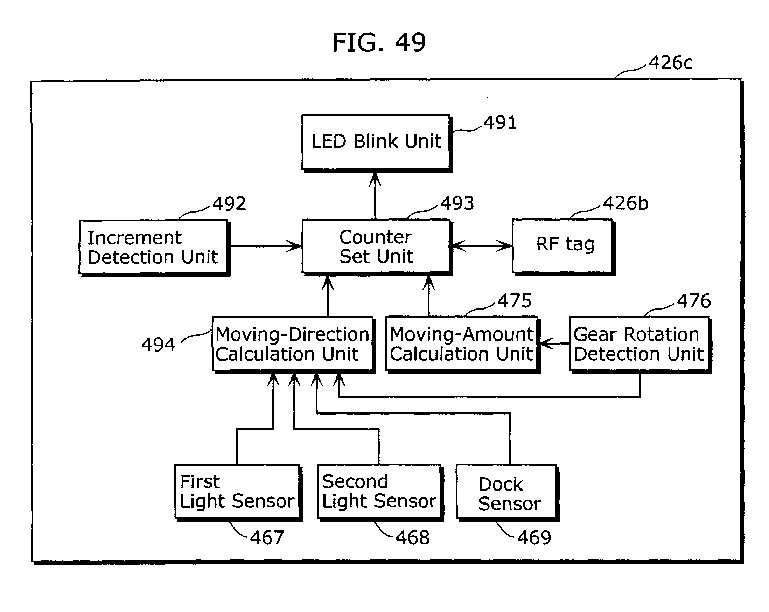

FIG. 49 is a block diagram showing an inside structure of the counter 426c. As shown in FIG. 49, the counter 426c further has a LED blink unit 491, an increment detection unit 492, a counter set unit 493, a RF tag 426b, a moving-direction calculation unit 494, a moving-amount calculation unit 475, and a gear rotation detection unit 476.

The gear rotation detection unit 476 is a processing unit which detects the number of rotations and a direction of rotation of the gear 426i. The moving-amount calculation unit 475 is a processing unit which calculates an amount of movement of a component tape, based on the number of rotations of the gear 426i that has been detected by the gear rotation detection unit 476. The moving-direction calculation unit 494 is a processing unit which calculates a direction of moving of the component tape, based on outputs of the gear rotation detection unit 476, the first light sensor 467, the second light sensor 468, and the dock sensor 469. The increment detection unit 492 is a processing unit which detects whether or not the count-up switch 426e is pressed.

Note that the already-described slide member 509 is not taken out from the component tape even if the component tape is taken out from the mounter 100, so that the slide member 509 is stocked together with the component tape into a storage cabinet for the component tape. Note also that the slide member 509 is kept equipped in the component tape counting the number of remaining components, until the components in the component tape are used up.

The counter set unit 493 is a processing unit which sets a counter value displayed on the display unit 426m, based on outputs of the increment detection unit 492, the moving-direction calculation unit 494, and the moving-amount calculation unit 475. The RF tag 426b is a memory unit which records the counter value set by the counter set unit 493. The LED blink unit 491 is a processing unit which causes the LED 426d to blink, based on instructions from the counter set unit 493.

Note that a positional relationship between the RF-tag reader/writer in the component cassette and the RF tag on the slide member is the same as shown in FIG. 31.
Note also that a path along which electronic components 423d stored in the component tape wound around the supply reel 426 is transported to be pickup by the line gang pickup head 112 is the same as shown in FIG. 32.

Note also that circuit structures of the RF-tag reader/writer 111 and the RF tag are the same as shown in FIG. 33.

The following summarizes operations characterized in this mounter 100 which are similar to the second embodiment.

### (1) Nozzle Interchanging

When a nozzle that is required for the next mounting operation is not present on the line gang pickup head 112, the line gang pickup head 112 is moved to the nozzle station 119 where nozzle interchanging is performed. The types of nozzles available depend on the sizes of the components to be picked up by the line gang pickup head 112. As one example, "type S", "type M", and "type L" nozzles may be provided.

### (2) Component Pickup

The line gang pickup head 112 moves to the component supply units 115a and 115b and picks up electronic components using suction. When ten components cannot be simultaneously picked up, the line gang pickup head 112 may be repositioned and may make several nozzle strokes to pick up a maximum of ten electronic components.

### (3) Recognition Scan

The line gang pickup head 112 moves past the component recognition camera 116 at a predetermined speed. The component recognition camera 116 forms images of all of the electronic components that have been picked up by the line gang pickup head 112 and detects whether the components have been picked up at the correct positions.

### (4) Component Mounting

Electronic components are successively mounted on the board 20.

The above operations (1) to (4) are repeated, thereby mounting all of the required electronic components onto the board 20. The operations (2) to (4) form the main operation of the mounter 100 when mounting components and correspond to a "task". This means that a maximum of ten electronic components can be mounted on a board in a single task.

### (Line Gang Pickup Head)

The line gang pickup head 112 has ten mounting heads that can independently pick up and mount electronic components arranged in a line. A maximum of ten pickup nozzles can be attached, so that a maximum of ten components can be picked up in a single nozzle stroke by the line gang pickup head 112.

Each of the heads (a part capable of picking up one component) that compose the line gang pickup head 112 is referred to in this description as a "mounting head" or simply as a "head".

The ten mounting heads that form the line gang pickup head 112 are arranged in a straight line, which places a restriction on the movable range of the line gang pickup head 112, both when picking up components and when mounting components. In more detail, as shown in FIG. 24, there are restrictions as to which mounting heads are able to access components that are located at either end of a component supply unit (which is to say, near the left end of the left component supply unit 115a and near the right end of the right component supply unit 115b).

When mounting electronic components onto a board, there are also restrictions on the movable range of the line gang pickup head 112.

### (Component Recognition Camera)

As the component recognition camera 116, the mounter 100 is equipped with a 2D camera that forms two-dimensional images and a 3D camera that can also detect height. As the 2D camera, a 2DS camera and 2DL camera are provided for use, depending on the size of the area to be photographed. The 2DS camera is capable of photographing a small area at high speed, and is characterized by having maximum view field of 60 mm by 220 mm. The 3D camera is used to detect in three dimensions whether any of the leads of an IC component are bent.

The recognition scanning speed used when photographing electronic components differs depending on the camera being used. When components that are photographed by the 2DS camera and components that are photographed by the 3D camera are present in the same task, recognition scanning needs to be performed at the scanning speed of each camera, making two scanning operations necessary.

### (Component Supply Units)

Electronic components may be packaged in the form of a component tape, where components are held by a tape, or in the form of a tray in the form of a plate whose area is partitioned in keeping with the dimensions of components.

The supply of taped components is performed by the component supply units 115a and 115b, while the supply of tray components is performed by the tray supply unit 117.

The taping of electronic components is standardized, and tapes with widths of 8 mm to 72 mm are available for different-sized components. By setting components that are held by a tape (or in other words, a "component tape") in a component cassette (a "tape cassette unit") with a suitable width for the tape width, electronic components can be reliably and consecutively obtained from the tape.

The component supply units in which component cassettes are set are designed so that component tapes with a width of up to 12 mm can be loaded with no gaps at a pitch of 21.5 mm. When the width of the tape is 16 mm or above, tapes need to be set leaving an appropriate gap that depends on the width of the tape. In order to pick up a plurality of electronic components simultaneously (i.e., in a single nozzle stroke for the line gang pickup head 112), the mounting heads and component cassettes should be aligned with the same pitch. When each component is supplied using a tape that is 12 mm wide or narrower, ten components can be simultaneously picked up by the line gang pickup head 112.

Note that the two component supply units (the component supply unit 115a and the component supply unit 115b) that compose each component supply unit are each capable of holding a maximum of 48 tapes that are 12 mm wide or narrower.

### (Component Cassettes)

Component cassettes can be single-cassette cassettes that only hold one component tape or double-cassette cassettes that hold a maximum of two cassettes. The two component tapes that are placed in the same double-cassette cassette need to have the same feed pitch (2 mm or 4 mm).

### (Component Number Management Apparatus)

The component number management apparatus 320 is an apparatus which manages the number of remaining components in the component tape stored in the component cassette 114.

The component number management apparatus 320 is realized when a general-purpose computer system, such as a personal computer, executes a component remaining number management program according to the third embodiment of the present invention.

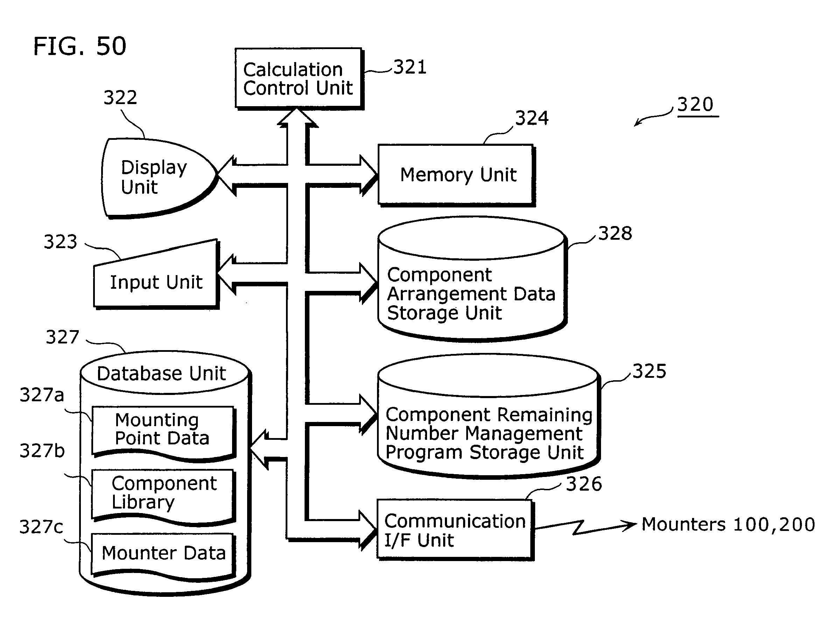

FIG. 50 is a block diagram showing a hardware configuration of the component number management apparatus 320. The component number management apparatus 320 is a computer apparatus which presents warning at shortage in the number of remaining components stored in the component tape in each mounter in the production line. The component number management apparatus 320 has a calculation control unit 321, a display unit 322, an input unit 323, a memory unit 324, a component remaining number management program storage unit 325, a communication interface (I/F) unit 326, a database unit 327, a component arrangement data storage unit 328, and the like.

The calculation control unit 321 is a Central Processing Unit (CPU), a numeric processor, or the like. The calculation control unit 321 loads the required programs from the component remaining number management program storage unit 325 into the memory unit 324 and executes them. In accordance with the execution result, the calculation control unit 321 controls the units 322 to 327.

The display unit 322 is a Cathode Ray Tube (CRT), a Liquid Crystal Display (LCD), or the like, while the input unit 323 is a keyboard, a mouse, or the like. Under the control of the calculation control unit 321, these units are used to allow operator interaction with the component number management apparatus 320.

The communication I/F unit 326 is, for example, a Local Area Network (LAN) adapter or the like, which is used when the component number management apparatus 320 and the mounter 100 or 200 communicate with each other, for example.

The memory 324 is, for example, a Random Access Memory (RAM) or the like, which provides a working area for the calculation control unit 321. The component number management program storage unit 325 is a hard disk or the like, in which various component remaining number management programs for realizing the functions of the component number management apparatus 320 are stored.

The database unit 327 is a hard disk or the like, in which mounting point data 327a, component library 327b, mounter data 327c, and the like used in component mounting by the mounter 100 are stored.

The component arrangement data storage unit 328 is a hard disk or the like, in which component arrangement data indicating positions in the Z-axis of component tapes, and the like are stored.

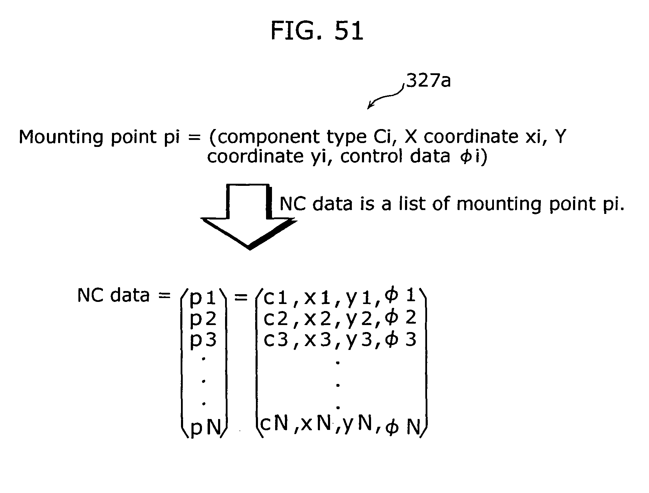

FIGS. 51 to 53 shows examples of the mounting point data 327a, the component library 327b, and the mounter data 327c, respectively.

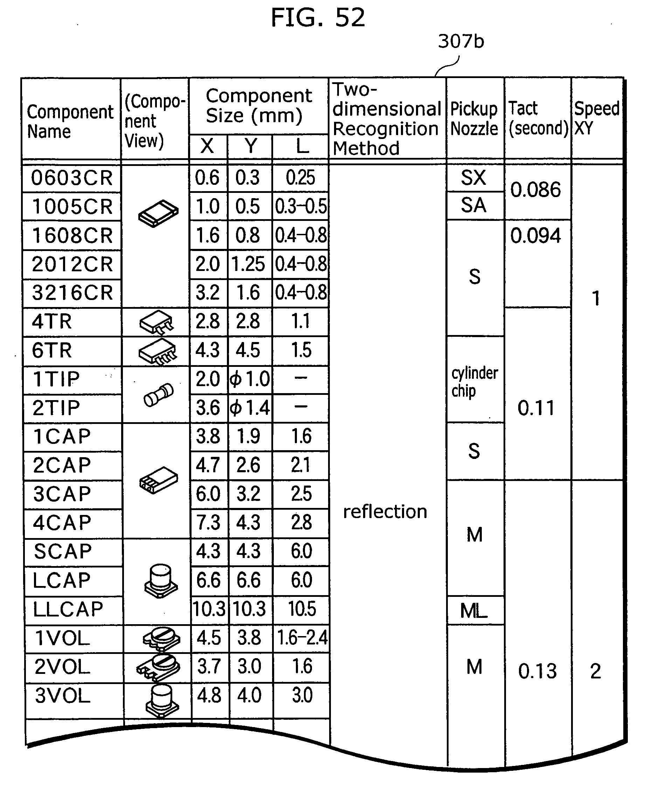

The mounting point data 327a is collection of information representing mounting points of all components to be mounted. As shown in FIG. 51, one mounting point pi is expressed by a component type Ci, X coordinates xi, Y coordinates yi, and control data ϕi. Here, the "component type" is equivalent to a component name in the component library 327b shown in FIG. 52. The "X coordinates" and the "Y coordinates" are coordinates of the mounting point (coordinates representing a specific position on a board). The "control data" is information of restrictions on mounting of the component type (a type of an applicable nozzle, a maximum moving speed of the line gang pickup head 112, and the like). Note that eventually obtained numeric control (NC) data represents an order of mounting points, by which a line tact becomes minimum.

The component library 327b is a library collecting information unique to each type of components which can be treated by the mounters 100 and 200. As shown in FIG. 52, the component library 327b indicates, per component type, a component size, a tact (tact time required for each component type under certain conditions), and other restriction information (a type of an applicable nozzle, a recognition method by the recognition camera 116, a maximum speed ratio of the line gang pickup head 112, and the like). In FIG. 52, an external view of each component type is added as a reference. The component library may further include information regarding a color or a shape of each component type.

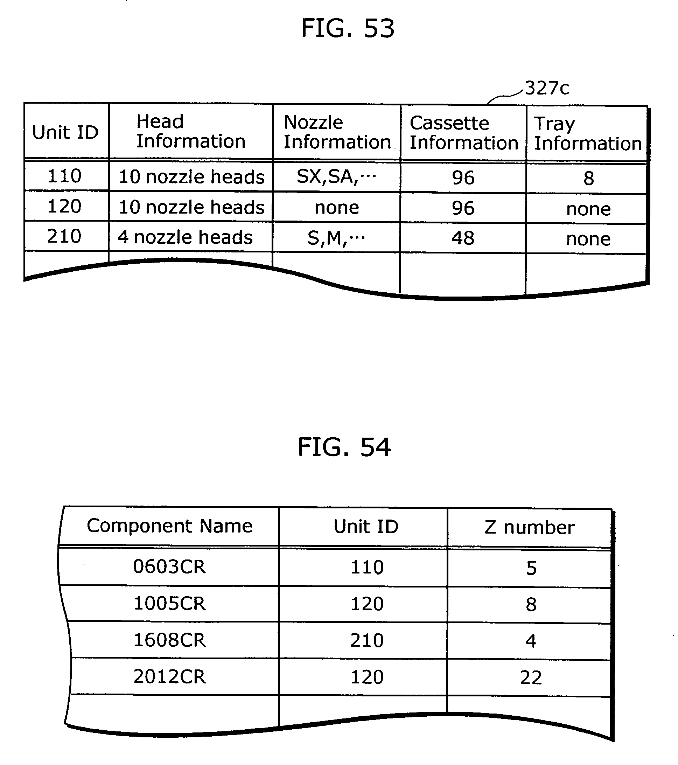

The mounter data 327c is information indicating apparatus structures of all mounters included in the production line, the above-described restrictions, and the like. As shown in FIG. 53, the mounter data 327c includes: unit IDs representing numbers of respective mounters; head information regarding types and the like of the line gang pickup heads; nozzle information regarding types and the like of pickup nozzles used in the line gang pickup head; cassette information regarding a maximum number and the like of the component cassettes 114; tray information regarding the number of trays and the like stored in the tray supply unit 117; and the like.

The above-described pieces of information are data called as followings. The pieces of the information are called: mounter option data (per mounter), resource data (the number of cassettes and the number of nozzles applicable per mounter), nozzle station arrangement data (per mounter with a nozzle station), initial nozzle pattern data (per mounter), Z-axis arrangement data (per mounter), and the like. Here, as the resources, it is assumed that the number of nozzles for each type, "SX", "SA", "S", or the like is 10 or more.

FIG. 54 is a diagram showing an example of the component arrangement data stored in the component arrangement data storage unit 328. The component arrangement data is data representing a position in the Z-axis of each taped component type to be arranged. The component arrangement data includes: a mounter number (unit ID) of a mounter in which a component cassette 114 storing the components of the type is set; a position in the Z-axis (Z number) of the component cassette 114. According to the component arrangement data, component cassettes 114 should be arranged.

### (Z Number Identifying and Splice Detecting)

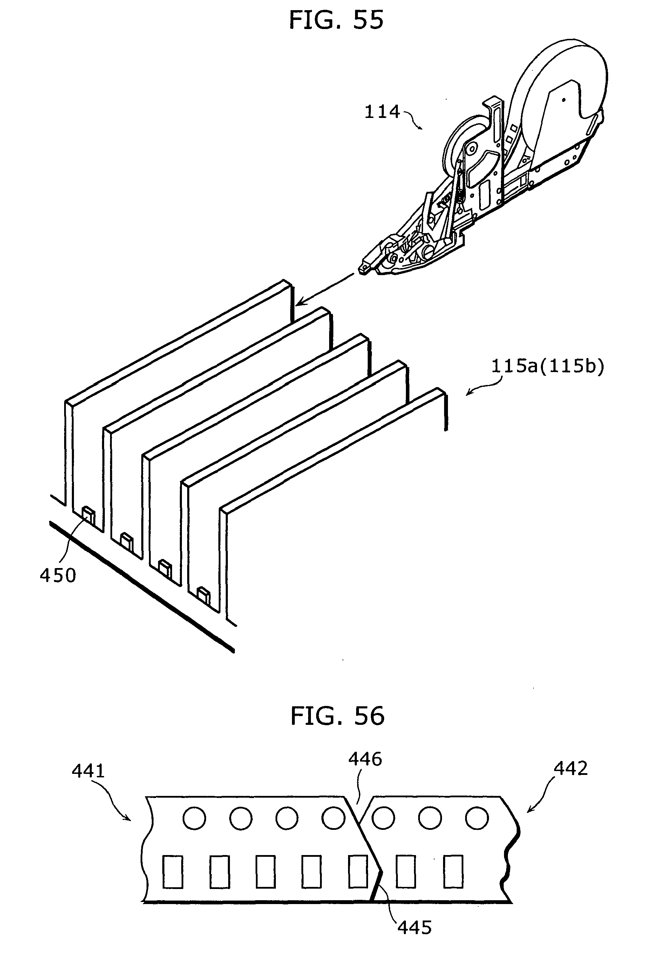

FIG. 55 is a view for explaining the component supply unit 115a or 115b in more detail. In each of the component supply units 115a and 115b, switches 450 and splice detection sensors 452 are equipped in respective Z numbers. Outputs of the switches 450 are connected to the above-described control unit 480.

Each of the switches 450 is electrically turned ON when the corresponding component cassette 114 is set into the component supply unit 115a or 115b. Based on output from the switch 450, the component number management apparatus 320 determines the Z number in which the component cassette 114 is set in the component supply unit 115a or 115b.

Each of the splice detection sensors 452 is a sensor which optically detects a splice between component tapes. FIG. 56 is a diagram showing the splice between component tapes. During component mounting, an end of the component tape 441 is connected with an end of another component tape 442, before the end of the component tape 441 is peeled off. With the connecting, the mounter 100 (200) does not need to stop for restoring components. Here, there is a cut in splice 445 between the component tapes 441 and 442. The splice detection sensor 452 optically detects the cut 446. Note that, besides the above sensor using optical detecting, any sensors may be used as far as they can detect the splice. Note also that, in the splicing of the component tape 441 and the component tape 442, the component tape 442 is spliced after a slide member 509 attached to the component tape 441 has been removed. When the splice 445 is detected, information indicating the detection is written by the RF-tag reader/writer 111 into the RF tag 426b.

### (Processing Performed by Counter)

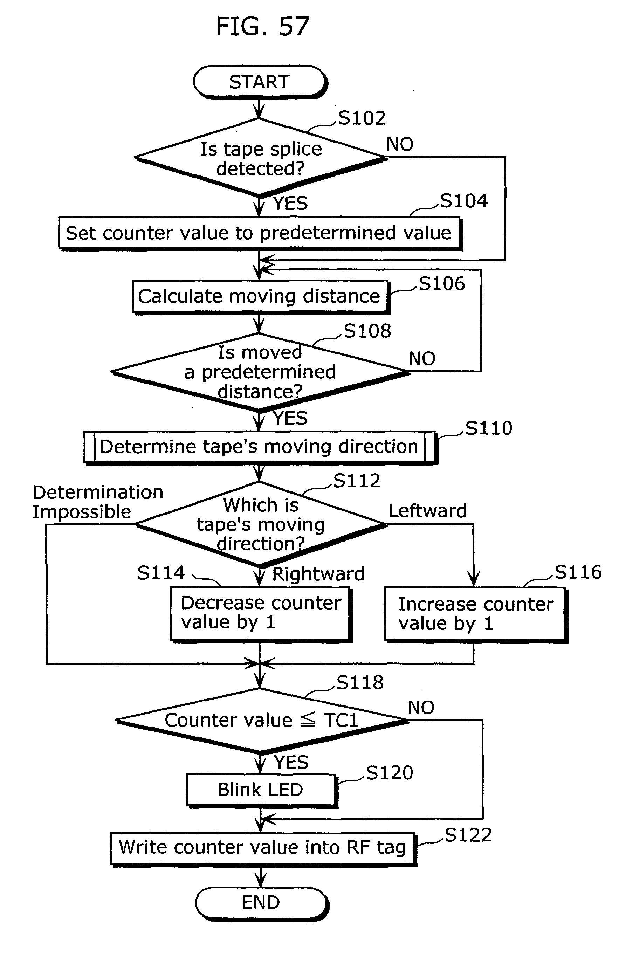

FIG. 57 is a flowchart of processing performed by the counter 426c.

Referring to the information recorded in the RF tag 426b, the counter set unit 493 determines whether or not the splice detection sensor 452 in the component number management apparatus 320 detects the splice 445 of the component tapes (S102). If the splice 445 is detected (YES at S102), then the counter set unit 493 sets a predetermined value as a counter value (S104). More specifically, on the display unit 426m of the counter 426c, the number of components stored in the newly spliced component tape is displayed. Note that the number of components stored in the component tape may be previously recorded in the RF tag 426b, or may be written by the RF-tag reader/writer 111 into the RF tag 426b. Here, after displaying the number of components on the display unit 426m, the counter set unit 493 deletes the information indicating the detection of the splice 445, from the RF tag 426b.

Note that, in this processing, it is assumed that the slide member 509 of the old component tape is passed through the splice 445 to be still used sliding along the new component tape. In such a case, the same slide member 509 can be used for both of the old component tape and the new spliced component tape.

Note also that the new component tape may have its own slide member 509 previously. In this case, when the old component tape is spliced with the new component tape, two slide members 509 exist on a component tape. Therefore, as one example, the number of components in the new component tape is read by the RF-tag reader/writer 111 when the splice 445 is detected, and then the obtained number is written into a RF tag 426b in a counter 426c of the slide member 509 in the old component tape. In such a case, the counter set unit 493 of the old component tape may add the number of components in the new component tape to the number of components in the old component tape, to be set as a counter value displayed on the display unit 426m. As a result, the counter 426c of the old component tape can manage the number of components in the new tape. Here, the slide member 509 of the new component tape is assumed to be removed.

Next, the moving-amount calculation unit 475 calculates an amount of movement of the component tape, based on the number of rotations of the gear 426i that has been detected by the gear rotation detection unit 476 (S106).

The counter set unit 493 determines whether or not the moving distance of the component tape reaches a predetermined distance (S108). The "predetermined distance" means a distance between two adjacent storage concaves 424a, in other words, a distance between adjacent components.

If the moving distance of the component tape reaches the predetermined distance (YES at S108), then the moving-direction calculation unit 494 determines to which direction the component tape is moved (S110). This moving direction determining (S110) will be described further below in more detail.

If the moving direction of the component tape is rightward in FIGS. 47 or 48 (in a direction shown by arrow B), in other words, if the component tape is pulled out and transported into the component cassette 114 (rightward at S112), then the counter set unit 493 decreases the counter value by 1 (S114). In other words, the remaining component number minus 1 is displayed on the display unit 426m.

If the moving direction of the component tape is leftward in FIGS. 47 or 48 (in a direction opposite to the direction shown by arrow B), in other words, if the component tape is pulled back and rewound around the supply reel 426 (leftward at S112), then the counter set unit 493 increases the counter value by 1 (S116). In other words, the remaining component number plus 1 is displayed on the display unit 426m.

If it is impossible to determine the moving direction of the component tape (determination impossible at S112), then the counter value is not changed.

The counter set unit 493 determines whether or not the counter value, that is the remaining component number, is equal to or less than a predetermined threshold value TC1 (S118). If the component remaining number is equal to or less than the threshold value TC1 (YES at S118), then the counter set unit 493 instructs the LED blink unit 491 to cause the LED 426d to blink (S120). Thereby, it is possible to urge the user to interchange the component tape to a new component tape.

Finally, the counter set unit 493 writes the counter value into the RF tag 426b (S122). By repeating the above-described processing by the counter 426c, the number of remaining components is displayed on the display unit 426m of the counter 426c. Thereby, the user can learn the number of remaining components at a glance.

### (Component Tape Moving Direction Determining)

Next, the determining of a moving direction of a component tape (S100 of FIG. 57) is described in more detail.

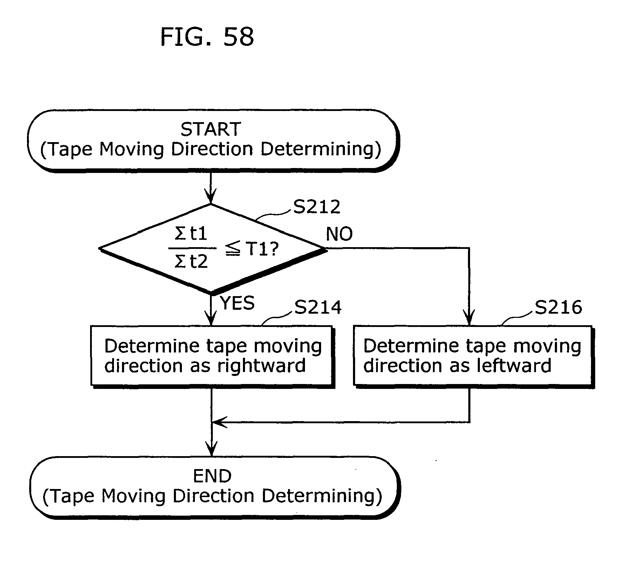

FIG. 58 is a flowchart of processing of calculating a moving direction of a component tape, based on outputs of the first light sensor 467 and the second light sensor 468.

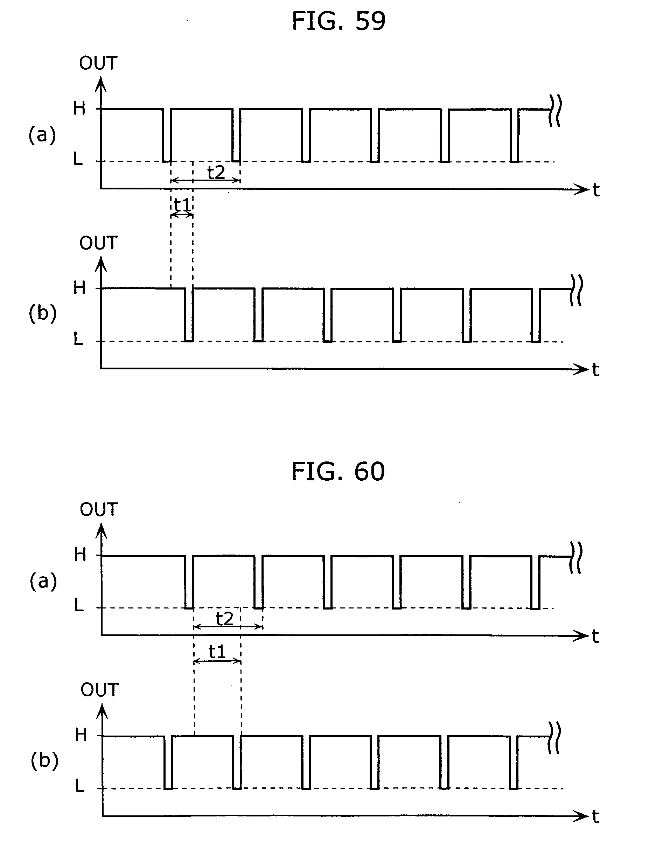

FIG. 59 shows charts of output voltages of the first light sensor 467 and the second light sensor 468, when the moving direction of the component tape is rightward. FIG. 59 (a) is a chart showing output voltages of the first light sensor 467, while FIG. 59 (b) is a chart showing output voltages of the second light sensor 468.

When the hole 425b and the hole 424b are detected, is outputted from each sensor. In other words, as shown in FIG. 48, when the component tape moves to the right (in a direction of arrow B), the second light sensor 468 becomes low level immediately after the first light sensor 467 becomes low level. Thereby, as shown in FIG. 59 (a), assuming that a time t1 represents a time period from when the first light sensor 467 detects a hole until when the second light sensor 468 detects the same hole, and that a time t2 is a time period from when the first light sensor 467 detects a hole until when the first light sensor 467 detects a next adjacent hole, it is understood that, in the waveform of the voltage values of the first light sensor 467, the time ti is much shorter than the time t2.

On the other hand, FIG. 60 shows charts showing output voltages of the first light sensor 467 and the second light sensor 468, when the moving direction of the component tape is leftward. FIG. 60 (a) is a chart showing output voltages of the first light sensor 467, while FIG. 60 (b) is a chart showing output voltages of the second light sensor 468. Assuming that the time ti and the time t2 as defined in the same manner of FIG. 59, a ratio of the time ti to the time t2 is longer than the case where the moving direction of the component tape is rightward.

Based on such characteristics of outputs of the light sensors, the moving direction is determined.
Regarding a time period during which the component tape moves a predetermined distance, the moving-direction calculation unit 494 sums all times ti to obtain a sum Σti, and all times t2 to obtain a sum Σt2. Then, the moving-direction calculation unit 494 determines whether or not a value of a ratio of Σt1 to Σt2 (Σt1/Σt2) is equal to or less than a predetermined threshold value T1 (S212).
If so (YES at S212), then the moving-direction calculation unit 494 determines that the moving direction of the component tape is rightward (S214). Otherwise (NO at S212), the moving-direction calculation unit 494 determines that the moving direction of the component tape is leftward (S216).

As described above, using the two light sensors, it is possible to determine the moving direction of the component tape.

### (Component Remaining Number Management)

Next, the component remaining number management performed by the component number management apparatus 320 is described in more detail.

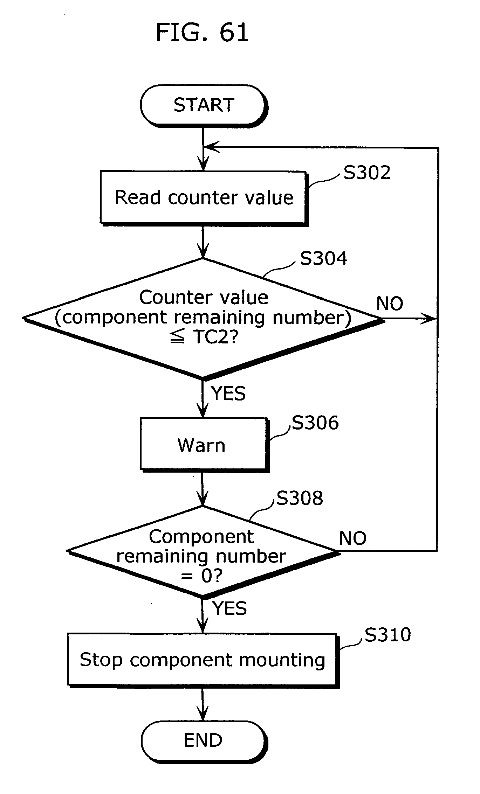

FIG. 61 is a flowchart of the component remaining number management. The component remaining number management is processing of management by which the number of remaining components stored in a component tape does not become 0. A program realizing the processing is stored in the component remaining number management program storage unit 325.

From the RF tag 426b embedded in the counter 426c, the component number management apparatus 320 reads the number of remaining taped components, in other words, the counter value (S302). The reading of the counter value is performed by the RF-tag reader/writer 111. When the counter value becomes equal to or less than the predetermined threshold value TC2 (YES at S304), the component number management apparatus 320 provides warning (S306). After the warning, the determination is made as to whether or not the component remaining number is 0 (S308). If the component remaining number is 0 (YES at S308), then the component mounting is stopped (S310).

Note that the warning may be blinking a warning ramp equipped in the mounter 100, displaying warning on a screen of the component number management apparatus 320, or any other methods.

As described above, according to the third embodiment, the counter 426c for counting the number of components is formed on the slide member 509 which is attached to the component tape and capable of sliding along the tape, and such counter 426c displays the count value. Thereby, using a simple and inexpensive method, the user can learn the number of remaining taped components, thereby managing the component remaining number.

In particular, the component remaining number is decreased during component mounting on a board, while the component remaining number is increased when winding the component tape around the supply reel, so that the counter can always display accurate component remaining number.

Furthermore, it is also possible to easily and surely perform the management of the number of remaining taped components in process, without an expensive host server.

The above has described the component mounting system according to the third embodiment, but the present invention is not limited to the this embodiment.

For example, the RF-tag reader/writer 111 may be replaced to a barcode reader. The barcode reader may read the number of remaining components stored in the component tape, by reading a barcode displayed on the display unit 426m of the counter 426c.

Note also that the moving amount calculation unit 475 may calculate the moving distance of the component tape, based on the number of holes detected by the first light sensor 467 or the second light sensor 468. Note also that, in the case where the carrier tape 424 is made of transparent material, the first light sensor 467 or the second light sensor 468 may directly detect existence of the taped components, and thereby calculate the moving distance of the component tape, or the counter value may be updated based on the outputs of the first light sensor 467 or the second light sensor 468.

Note that the gear 426i may be replaced to a round-shaped member, such as a rubber roller.
Note also that the number of used components may be counted instead of the number of remaining components. In the case of counting the number of used components, the component number is increased when the component tape is pulled out, while the component number is decreased when the component tape is pulled back to be re-wound.

Note also that the third embodiment has described that the moving direction of the component tape is determined using the first light sensor 467 and the second light sensor 468 (S100 of FIG. 57, FIG. 58), but the method of determining the moving direction is not limited to the above and may be any other methods. The following describes three other examples for determining the moving direction.

### (First Variation)

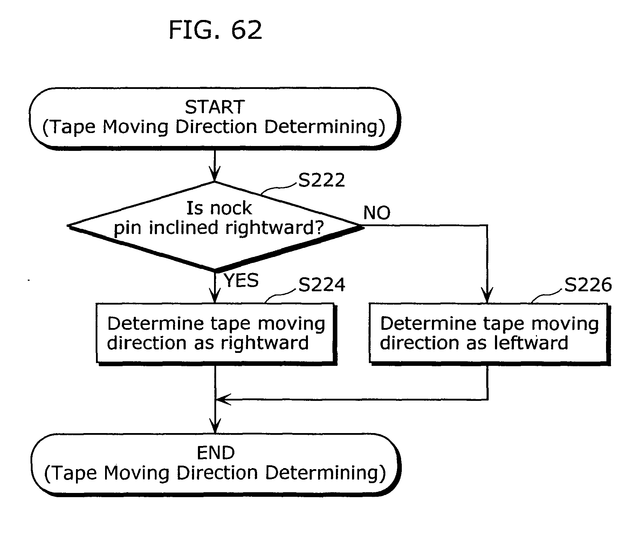

FIG. 62 is a flowchart of processing of determining the moving direction of the component tape (S110 of FIG. 57) using a dock sensor.

In the same manner as described above, a dock sensor 469 determines the moving direction of the component tape, based on inclination of the knock pin 466.

The moving-direction calculation unit 494 determines whether or not the knock pin 466 is inclined to the right in FIG. 48 (S222). If the inclination is rightward (YES at S222), then the moving-direction calculation unit 494 determines that the moving direction of the component tape is rightward (in a direction of arrow B) in FIG. 48 (S224). On the other hand, if the inclination is leftward (NO at S222), then the moving-direction calculation unit 494 determines that the moving direction of the component tape is leftward (in a direction opposite to the arrow B) in FIG. 48 (S226). Note that, in the case where, during moving of the component tape in a predetermined distance, the inclination of the knock pin 466 varies rightward and leftward, it is possible to determine that the moving direction of the component tape cannot be determined.

### (Second Variation)

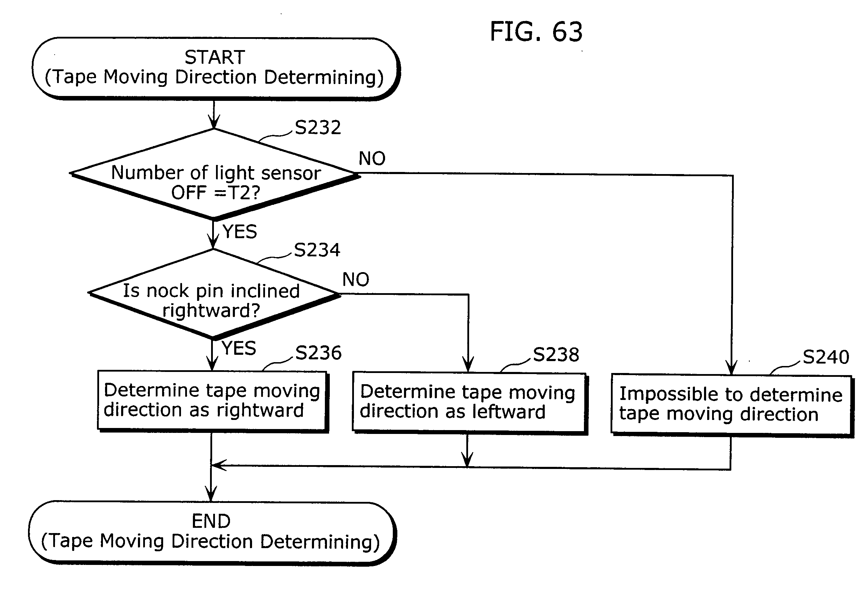

FIG. 63 is a flowchart of processing of determining the moving direction of the component tape (S110 of FIG. 57) using the dock sensor 469 and the first light sensor 467.

During movement of the component tape in a predetermined distance, the moving-direction calculation unit 494 determines whether or not the number of times of turning OFF of the light sensor of the first light sensor 467 (the number of low level outputs) is a predetermined number T2 (S232). This number T2 represents the number of holes which have passed the light sensor during the movement of the component tape in a predetermined distance in a predetermined direction.

If the number is not the number T2 (NO at S232), then the moving-direction calculation unit 494 determines that the moving direction of the component tape is changed during the moving in the predetermined distance, and eventually that the moving direction of the component tape cannot be determined (S240).

On the other hand, if the number is the number T2 (YES at S232), then moving-direction calculation unit 494 determines whether or not the knock pin 466 is inclined to the right in FIG. 48 (S234). If the inclination is rightward (YES at S234), then the moving-direction calculation unit 494 determines that the moving direction of the component tape is rightward (in a direction of arrow B) in FIG. 48 (S236). On the other hand, if the inclination is leftward (NO at S234), then the moving-direction calculation unit 494 determines that the moving direction of the component tape is leftward (in a direction opposite to the arrow B) in FIG. 48 (S238). Here, it is obvious that the first light sensor 467 may be replaced to the second light sensor 468.

### (Third Variation)

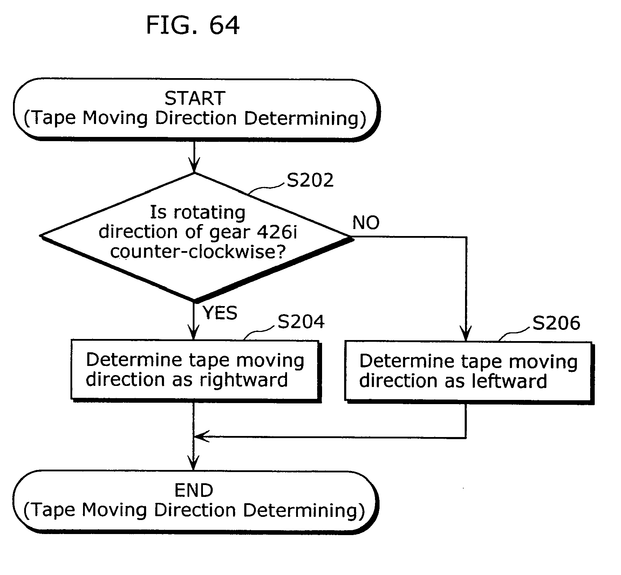

FIG. 64 is a flowchart of processing of determining the moving direction of the component tape (S110 of FIG. 57), based on a rotating direction of the gear 426i of FIG. 48.

The moving-direction calculation unit 494 determines whether or not a rotating direction of the gear 426i is counter-clockwise as shown by an arrow of FIG. 48 (S202). If the rotating direction is clockwise (YES at S202), then the moving-direction calculation unit 494 determines that the moving direction of the component tape is rightward (in a direction of arrow B) in FIG. 47 (S204). On the other hand, if the rotating direction is counter-clockwise (NO at S202), then the moving-direction calculation unit 494 determines that the moving direction of the component tape is leftward (in a direction opposite to the arrow B) in FIG. 47 (S206).

### Industrial Applicability

The maintenance method and the component mounter according to the present invention can be applied to a maintenance method for a component mounter for mounting electronic components onto a board, the component mounter, and the like. Examples of the applications are a maintenance method for each device included in a component mounter or each part included in such device, the component mounter using such a maintenance method, and the like. The present invention can also be applied to a component stock management system and the like, by which taped components and the like used in the mounter are managed.

## Claims

1. A maintenance method for maintaining a component mounter which mounts a component onto a board, said method comprising steps of:
reading maintenance information regarding maintenance for each of devices included in the component mounter or each of parts included in the device, from a radio frequency (RF) tag attached to the device; and
determining whether or not maintenance is necessary for the part, based on the read maintenance information.

2. The maintenance method according to Claim 1, further comprising a step of
determining a position of the device, using a signal received from the RF tag attached to the device included in the component mounter,
wherein, in said reading, the maintenance information is read from the RF tag attached to the device located at the position determined in said determining of the position.

3. The maintenance method according to Claim 2,
wherein an antenna is arranged by the RF tag in order to read the maintenance information from the RF tag, and
in said reading, the maintenance information is read from the RF tag attached to the device located at the position determined in said determining of the position, via the antenna arranged by the RF tag.

4. The maintenance method according to Claim 1, further comprising a step of
warning when the maintenance is determined necessary in said determining of the maintenance necessity.

5. The maintenance method according to Claim 4,
wherein, in said warning, a first warning is provided during a predetermined period prior to a use limit of the device or the part, while a second warning is provided after the use limit.

6. The maintenance method according to Claim 1,
wherein the maintenance information includes at least one of the number of uses, a used time period, the number of errors, the number of pickups, a repair history, a maintenance history, the number of mountings, a use deadline of the part, regarding each of the devices or each of the parts, and
in said determining of the maintenance necessity, it is determined that the maintenance is necessary for the part, when the maintenance information regarding the device or the part reaches a predetermined limitation value.

7. The maintenance method according to Claim 1, further comprising a step of
writing a use history of the device or the part, as the maintenance information, into the RF tag, during driving the component mounter or during stopping the driving.

8. The maintenance method according to Claim 7,
wherein, in said writing, the maintenance information is reset to an initial value to be written, when the device or the part is interchanged for another device or another part, the maintenance information being regarding each device or each part and recorded in the RF tag.

9. The maintenance method according to Claim 1,
wherein the device is a component cassette in which the component is stored, and
the part is at least one of a spring, a shutter, a feeding part, and a case, which are included in the component cassette.

10. The maintenance method according to Claim 1,
wherein the device is a nozzle which picks up the component, and
the part is at least one of a spring, a shutter, a flange, a filter, and a case, which are included in the nozzle.

11. The maintenance method according to Claim 1,
wherein the maintenance information includes at least one of a maximum acceleration, shock resistance, a temperature, and humidity, the maximum acceleration and the shock resistance being regarding the component cassette as the device, and the temperature and the humidity being environment values, and
in said determining of the maintenance necessity, maintenance is determined necessary for the component cassette, when one of the maximum acceleration, the shock resistance, and the temperature, and the humidity, which are set for the component cassette, reaches a use maximum value.

12. The maintenance method according to Claim 1,
wherein the maintenance information includes information regarding one of a pickup rate of picking the components and a mounting rate of mounting the components, and
in said determining of the maintenance necessity, for each type of the components, the maintenance is determined necessary when one of the pickup rate and the mounting rate is lower than a predetermined value.

13. The maintenance method according to Claim 1,
wherein the device is a nozzle which picks up the component, and
the nozzle includes at least one of a flow amount sensor, a light amount sensor, an air pressure sensor, and a mounting pressure sensor, which are used to manage the maintenance information.

14. The maintenance method according to Claim 1,
wherein the device is a component cassette which stores a component tape that supplies the component, and
in said determining of the maintenance necessity, it is determined whether or not an operation using a relationship between the component cassette and the component tape is correct, based on information regarding a specification of the component cassette and another information regarding a specification of the component tape, these information being read from a RF tag attached to the component cassette and from a RF tag attached to the component tape, respectively, in said reading.

15. The maintenance method according to Claim 1, further comprising a step of
stopping the component mounter when the maintenance is determined necessary in said determining of the maintenance necessity.

16. The maintenance method according to Claim 1,
wherein the RF tag is attached to a component storage body in which the component is stored,
the maintenance information includes the number of the components stored in the component storage body,
in said reading, the number of the components is read from a RF tag attached to the component storage body, and
said maintenance method further comprises steps of:
updating the read number of the components, when the components are mounted onto the board; and
writing the updated number of the components into the RF tag.

17. The maintenance method according to Claim 16, further comprising steps of:
sending the number of the components, from the component mounter to a component stock management apparatus which manages stock data indicating stock information of the components; and
updating, in the component stock management apparatus, the stock information of the components based on the number of the components, the stock information being recorded in the stock data, and the number being received from the component mounter.

18. The maintenance method according to Claim 17, further comprising a step of
registering, in the stock management apparatus, a status regarding the components into the stock data.

19. The maintenance method according to Claim 18, further comprising steps of:
sending, from the component mouner to the stock management apparatus, data indicating that the components are in process, when the components are being mounted onto the board; and
receiving the data indicating that the components are in process, by the stock management apparatus from the component mounter,
wherein, in said registering, the stock management apparatus registers the data indicating that the components are in process, into the stock data.

20. The maintenance method according to Claim 18, further comprising steps of:
determining, in the component mounter, whether or not the number of components becomes 0 due to the mounting of the components onto the board;
sending, from the component mouner to the stock management apparatus, data indicating that a component storage body in which the components have been stored is to be collected, when the number of the components is determined as 0; and
receiving the data indicating that the component storage body is to be collected, by the stock management apparatus from the component mounter,
wherein, in said registering, the stock management apparatus registers the data indicating that the component storage body is to be collected, into the stock data.

21. The maintenance method according to Claim 18, further comprising steps of:
sending, from the component mouner to the stock management apparatus, data indicating that collection is waited in process, which is a status where the components are to be restocked, when the mounting of the components onto the board is complete; and
receiving the data indicating that collection is waited in process, by the stock management apparatus from the component mounter,
wherein, in said registering, the stock management apparatus registers the data indicating that collection is waited in process, into the stock data.

22. The maintenance method according to Claim 18,
wherein, in said registering, the stock management apparatus registers data indicating that the components are stocked, into the stock data, when the stock management apparatus receives the data.

23. The maintenance method according to Claim 16,
wherein the RF tag is arranged at a position on the component storage body, so that data recorded in the RF tag is capable of being read out anytime.

24. The maintenance method according to Claim 23,
wherein the component storage body is a component tape, and
the RF tag is arranged at beginning of the component tape.

25. The maintenance method according to Claim 23,
wherein the component storage body is a component tape,
the component tape has a member which is capable of sliding along the component tape, and
the RF tag is attached to the member.

26. The maintenance method according to Claim 25, further comprising steps of:
detecting a splice between the component tapes;
setting the number of the components to a predetermined value, when the splice between the component tapes is detected.

27. A maintenance apparatus which maintains a component mounter that mounts a component onto a board, said apparatus comprising:
a reading unit operable to read maintenance information regarding maintenance for each device included in the component mounter or each part included in the device, from a radio frequency (RF) tag attached to the device; and
a determining unit operable to determine whether or not maintenance is necessary for the part, based on the read maintenance information.

28. A component mounter which mounts a component onto a board, said component mounter comprising:
a reading unit operable to read maintenance information regarding maintenance for each device included in said component mounter or each part included in the device, from a radio frequency (RF) tag attached to the device; and
a determining unit operable to determine whether or not maintenance is necessary for the part, based on the read maintenance information.

29. A method of driving a component mounter which mounts a component onto a board, said method comprising steps of:
reading maintenance information regarding maintenance for each device included in the component mounter or each part included in the device, from a Radio Frequency (RF) tag attached to the device; and
determining whether or not maintenance is necessary for the part, based on the read maintenance information.

30. A program realizing a maintenance method of maintaining a component mounter which mountes a component onto a board, said program causing a computer to execute steps of:
reading maintenance information regarding maintenance for each device included in the component mounter or each part included in the device, from a radio frequency (RF) tag attached to the device; and
determining whether or not maintenance is necessary for the part, based on the read maintenance information.
